# EUROPEAN PATENT APPLICATION

(11) **EP 4 604 184 A1**
(43) Date of publication of application: **20.08.2025**
(21) Application number: 22962166.9
(22) Date of filing: 14.10.2022
(51) Int. Cl.: H01L 33/40, H01L 33/44, H01L 33/22, H01L 33/38, H01L 27/12, H01L 27/15, H01L 25/075

(54) **SEMICONDUCTOR LIGHT EMITTING ELEMENT AND DISPLAY DEVICE**

(71) Applicant: LG Electronics Inc., Yeongdeungpo-gu Seoul 07336 (KR)
(72) Inventor: PARK, Hyungjo, Seoul 06772 (KR); HWANG, Sunghyun, Seoul 06772 (KR); HEO, Mihee, Seoul 06772 (KR); KANG, Byungjun, Seoul 06772 (KR)
(74) Representative: Schornack, Oliver
(86) International application number: PCT/KR2022/015585
(87) International publication number: WO 2024/080416

(57) **Abstract**

The semiconductor light emitting element may include a light emitting layer having a first region and a second region surrounding the first region, a passivation layer surrounding a lateral part of the light emitting layer, an insulating layer under the first region, a first electrode under the light emitting layer, and a second electrode on the light emitting layer. The first electrode may include a reflective layer having a shape corresponding to a shape of the insulating layer under the insulating layer, and an ohmic contact layer under the second region.

## Description

### [Technical Field]

The embodiment relates to a semiconductor light emitting element and a display device.

### [Background Art]

A large-area display includes a liquid crystal display (LCD), an OLED display, and a micro-LED display.

A micro-LED display is a display that uses micro-LEDs, which are a semiconductor light emitting elements with a diameter or cross-sectional area of 100µm or less, as display elements.

Since a micro-LED display uses micro-LED, which are semiconductor light emitting elements, as display elements, it has excellent performance in many characteristics such as contrast ratio, response speed, color reproducibility, viewing angle, brightness, resolution, lifespan, luminous efficiency, or luminance.

In particular, a micro-LED display has the advantage of being able to freely adjust the size or resolution by separating and combining the screen in a modular manner, and the advantage of being able to implement a flexible display.

However, since a large micro-LED display requires millions or more micro-LEDs, there is a technical problem that makes it difficult to quickly and accurately transfer micro-LEDs to a display panel.

Recently developed transfer technologies include the pick and place process, the laser lift-off method, and the self-assembly method.

Among these, the self-assembly method is a method in which semiconductor light emitting elements find their assembly positions within a fluid, which is advantageous for implementing a large-screen display device.

However, research on the technology for manufacturing displays through self-assembly of micro-LEDs is still insufficient.

In particular, in the case of rapidly transferring millions or more semiconductor light emitting elements to a large display in a conventional technology, the transfer speed is improved, but the transfer error rate increases, which causes a technical problem in that the transfer yield decreases.

In the related technology, a self-assembly transfer process using dielectrophoresis (DEP) is being attempted, but there is a problem that the self-assembly rate is low due to the non-uniformity of the DEP force.

Meanwhile, a semiconductor light emitting element such as a micro-LED has a problem that luminance is reduced as the size decreases. In particular, the luminance of red semiconductor light emitting elements is lower than that of blue or green semiconductor light emitting elements due to the material properties. Therefore, the development of technology that can improve the luminance of the semiconductor light emitting element is urgent.

In addition, in order for semiconductor light emitting elements to react immediately to the magnet used in the self-assembly method, the magnetization force of the semiconductor light emitting elements must be large, but there is a limit to increasing the magnetization force due to the very small size of the semiconductor light emitting elements. Accordingly, there is a problem that the assembly rate is low in the self-assembly process.

In addition, after the semiconductor light emitting elements are self-assembled, the electrical connections of the semiconductor light emitting elements are formed. According to a non-public internal technology, a technology has been developed in which a connecting electrode is formed on the lateral part of a semiconductor light emitting element after the semiconductor light emitting element is assembled. However, since a space margin on a lateral part of the semiconductor light emitting element within an assembly hole is small, electrical connection is not easy, so that there is a problem that electrical connection defect occurs.

### [Disclosure]

### [Technical Problem]

An object of the embodiment is to solve the foregoing and other problems.

Another object of the embodiment is to provide a semiconductor light emitting element and a display device capable of improving luminous efficiency and light luminance.

In addition, another object of the embodiment is to provide a semiconductor light emitting element and a display device capable of improving assembly rate.

In addition, another object of the embodiment is to provide a semiconductor light emitting element and a display device capable of preventing electrical connection defect.

The technical problems of the embodiments are not limited to those described in this item and comprise those that may be understood through the description of the invention.

### [Technical Solution]

According to one aspect of the embodiment to achieve the above or other purposes, a semiconductor light emitting element, comprising: a light emitting layer having a first region and a second region configured to surround the first region; a passivation layer configured to surround a lateral part of the light emitting layer; an insulating layer under the first region; a first electrode under the light emitting layer; and a second electrode on the light emitting layer, wherein the first electrode comprises: a reflective layer having a shape corresponding to a shape of the insulating layer under the insulating layer; and an ohmic contact layer under the second region.

The ohmic contact layer may surround the reflective layer.

The ohmic contact layer may have a step difference under the first region and the second region.

The ohmic contact layer may have a straight plane under the first region and the second region.

The ohmic contact layer may comprise a first ohmic contact layer under the first region; and a second ohmic contact layer having a thickness greater than a thickness of the first ohmic contact layer under the second region.

A lower side of the first region of the light emitting layer may have a recess, and the insulating layer and the reflective layer may be disposed in the recess.

The ohmic contact layer may comprise a protrusion part in the recess. The protrusion part may surround the insulating layer in the recess. The protrusion part may surround the reflective layer in the recess.

The first electrode may comprise: a magnetic layer under the ohmic contact layer.

The magnetic layer may be in contact with the ohmic contact layer under the first region. The magnetic layer may be in contact with the reflective layer under the first region.

The ohmic contact layer may surround a second lateral part of the light emitting layer.

The magnetic layer may be disposed on the ohmic contact layer on the second lateral part of the light emitting layer.

The passivation layer may comprise an opening on an upper side of the light emitting layer, and the insulating layer may have a shape corresponding to a shape of the opening.

The second electrode may comprise a transparent conductive layer.

An upper surface of the light emitting layer may comprise a light extraction pattern.

The semiconductor light emitting element may have a size of micrometers or less.

According to another aspect of the embodiment, a display device, comprising: a backplane substrate; a semiconductor light emitting element in an assembly hole of the backplane substrate; a connecting electrode on a lateral part of the semiconductor light emitting element in the assembly hole; and an electrode wiring on the semiconductor light emitting element, wherein the semiconductor light emitting element may comprise a light emitting layer having a first region and a second region configured to surround the first region; a passivation layer configured to surround a lateral part of the light emitting layer; an insulating layer under the first region; a first electrode under the insulating layer; and a second electrode on the light emitting layer, wherein the first electrode may comprise a reflective layer having a shape corresponding to a shape of the insulating layer under the insulating layer; and an ohmic contact layer under the second region, wherein the connecting electrode may connect the first electrode of the semiconductor light emitting element and at least one or more of the first assembly wiring or the second assembly wiring, and wherein the electrode wiring may be connected to the second electrode of the semiconductor light emitting element.

The connecting electrode may be in contact with a lower surface of the first electrode of the semiconductor light emitting element.

### [Advantageous Effects]

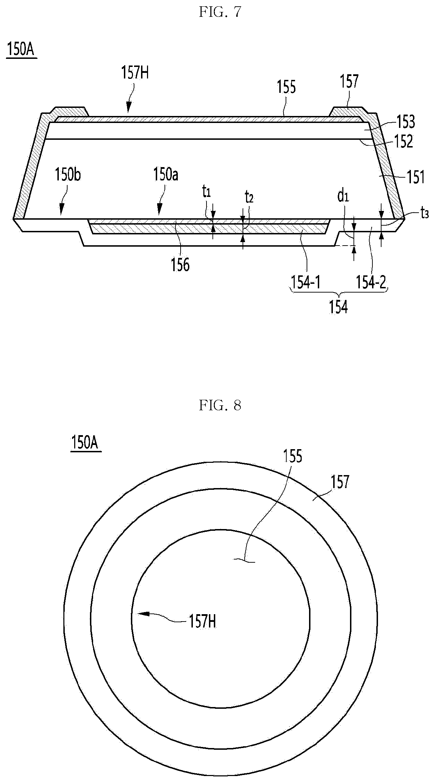

In an embodiment, as illustrated in FIG. 7, FIG. 22, FIG. 24, and FIG. 25, an omni-directional reflector (ODR) may be formed by an insulating layer 156 and a reflective layer 154-1 on the lower side of the light emitting layer 151 to 153, thereby increasing the reflectivity. The reflective layer 154-1 may be included in the first electrode 154 disposed on the lower side of the light emitting layer 151 to 153.

In an embodiment, as shown in FIG. 7, FIG. 22, FIG. 24, and FIG. 25, an insulating layer 156 may be disposed under a first region 150a of the light emitting layer 151 to 153, and an ohmic contact layer 154-2 may be disposed under a second region 150b surrounding the first region 150a. At this time, the insulating layer 156 may be used as a current blocking layer. Accordingly, the current of the light emitting layer 151 to 153 may not be concentrated on the first region 150a, but may be evenly distributed to the second region 150b together with the first region 150a, thereby increasing the luminous efficiency and improving the light luminance. The ohmic contact layer 154-2 may be included in the first electrode 154 disposed on the lower side of the light emitting layer 151 to 153.

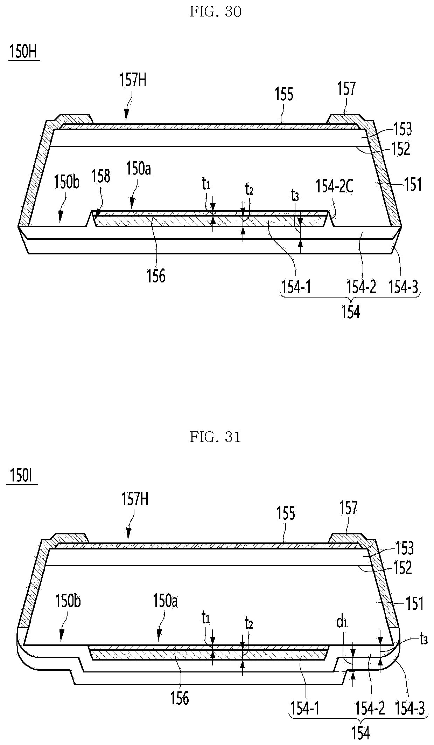

In an embodiment, as illustrated in FIG. 31 and FIGS. 33 to 35, the ohmic contact layer 154-2 may be disposed not only under the second region 150b of the light emitting layer 151 to 153 but also on a lateral part of the light emitting layer 151 to 153. Accordingly, current may be further distributed toward the lateral part of the light emitting layer 151 to 153, so that the luminous efficiency can be further increased and the light luminance can be significantly improved.

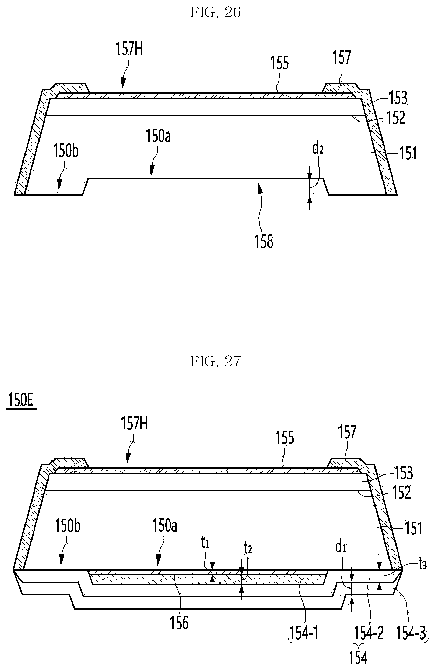

In an embodiment, as illustrated in FIGS. 27 to 30, a magnetic layer 154-3 may be disposed not only on the lower side of the light emitting layer 151 to 153 but also on the lateral part of the light emitting layer 151 to 153. Accordingly, the magnetization force of the magnetic layer 154-3 can be increased, so that the reaction speed of the semiconductor light emitting elements 150E, 150F, 150G, and 150H to the magnet during self-assembly can be increased, thereby improving the assembly rate.

In the embodiment, as illustrated in FIG. 7, since the lower side of the light emitting layer 151 to 153 has a non-uniform surface, an area of the semiconductor light emitting element 150A in contact with a bottom surface of a chamber or an upper surface of a display substrate during self-assembly can be reduced. Accordingly, the semiconductor light emitting element 150A is not adsorbed on the bottom surface of the chamber or the upper surface of the display substrate, thereby improving the assembly rate.

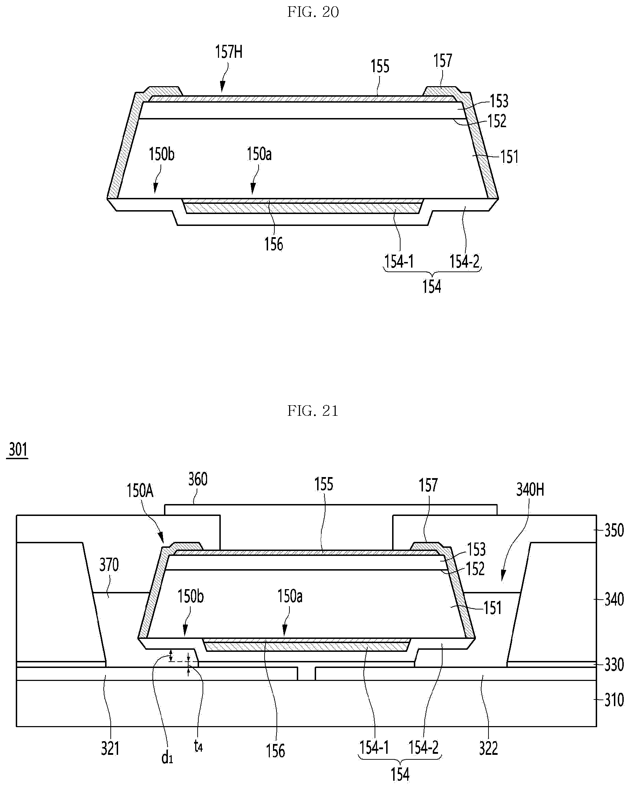

In the embodiment, as illustrated in FIG. 7, an insulating layer 156 and a reflective layer 154-1 may disposed under the first region 150a of the light emitting layer 151 to 153, and an ohmic contact layer 154-2 disposed under the first region 150a and the second region 150b of the light emitting layer 151 to 153 may surround the insulating layer 156 and the reflective layer 154-1. Accordingly, a step difference d₁ equal to the thickness t₁ of the insulating layer 156 and the thickness t₂ of the reflective layer 154-1 may be formed in the ohmic contact layer 154-2. As illustrated in FIG. 21, after the semiconductor light emitting element 150A illustrated in FIG. 7 is assembled into the assembly hole 340H of the backplane substrate, a connecting electrode 370 may be formed.

At this time, the connecting electrode 370 may be formed in a space between the lateral part of the semiconductor light emitting element 150A and the inner surface of the assembly hole, as well as between the second region 150b of the light emitting layer 151 to 153 and the first assembly wiring 321 and/or the second assembly wiring 322. Here, the space is defined by a space between the lower surface of the second region 150b of the semiconductor light emitting element 150A and the upper surface of the first assembly wiring 321 and/or the second assembly wiring 322, and the space may be equal to the sum of the step difference d₁ and the thickness t₄ of the first insulating layer 156.

In this way, since the connecting electrode 370 is formed not only on the lateral part of the light emitting layer 151 to 153 but also on the lower side of the light emitting layer 151 to 153, the electrical contact area between the ohmic contact layer 154-2 and the light emitting layer 151 to 153 can be maximized, so that the luminous efficiency and the light luminance can be significantly improved. In particular, the insulating layer 156 is disposed under the first region 150a of the light emitting layer 151 to 153 to obstruct the current flow, and since the ohmic contact layer 154-2 is disposed not only on the lower side of the light emitting layer 151 to 153 but also on the lateral part, the current may flow to the ohmic contact layer 154-2 through not only the edge region of the lower side of the light emitting layer 151 to 153 but also the lateral part of the light emitting layer 151 to 153. Thus, the current spreading effect can be maximized, so that the light luminance can be further improved. In addition, since the lower side as well as the lateral part of the light emitting layer is fixed by the connecting electrode, the fixation of the semiconductor light emitting element 150A can be strengthened, and product reliability can be improved.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 illustrates a living room of a house in which a display device according to an embodiment is disposed.
FIG. 2 is a block diagram schematically showing a display device according to an embodiment.
FIG. 3 is a circuit diagram showing an example of a pixel of FIG. 2.
FIG. 4 is an enlarged view of a first panel region of the display device of FIG. 1.
FIG. 5 is an enlarged view of a region A2 of FIG. 4.
FIG. 6 is a drawing illustrating an example of a light emitting element according to an embodiment being assembled on a substrate by a self-assembly method.
FIG. 7 is a cross-sectional view illustrating a semiconductor light emitting element according to a first embodiment.
FIG. 8 is a plan view illustrating a semiconductor light emitting element according to the first embodiment.
FIG. 9 is a bottom view illustrating a semiconductor light emitting element according to the first embodiment.
FIG. 10A illustrates current flow in a semiconductor light emitting element according to a comparative example.
FIG. 10B illustrates current flow in a semiconductor light emitting element according to an embodiment.
FIG. 11A illustrates light reflection in a semiconductor light emitting element according to a comparative example.
FIG. 11B illustrates reflectivity before and after heat treatment.
FIG. 12A illustrates light reflection in a semiconductor light emitting element according to an embodiment.
FIG. 12B illustrates the reflectivity of each of the comparative example, the first embodiment, and the second embodiment under a first experimental condition.
FIG. 12C illustrates the reflectivity of each of the comparative example, the first embodiment, and the second embodiment under a second experimental condition.
FIGS. 13 to 20 illustrate a manufacturing process of a semiconductor light emitting element according to the first embodiment.
FIG. 21 is a cross-sectional view illustrating a display device according to a first embodiment.
FIG. 22 is a cross-sectional view illustrating a semiconductor light emitting element according to a second embodiment.
FIG. 23 is a bottom view illustrating a semiconductor light emitting element according to the second embodiment.
FIG. 24 is a cross-sectional view illustrating a semiconductor light emitting element according to a third embodiment.
FIG. 25 is a cross-sectional view illustrating a semiconductor light emitting element according to a fourth embodiment.
FIG. 26 is a cross-sectional view illustrating a state in which a recess is formed in a light emitting layer.
FIG. 27 is a cross-sectional view illustrating a semiconductor light emitting element according to a fifth embodiment.
FIG. 28 is a cross-sectional view illustrating a semiconductor light emitting element according to a sixth embodiment.
FIG. 29 is a cross-sectional view illustrating a semiconductor light emitting element according to a seventh embodiment.
FIG. 30 is a cross-sectional view illustrating a semiconductor light emitting element according to an eighth embodiment.
FIG. 31 is a cross-sectional view illustrating a semiconductor light emitting element according to a ninth embodiment.
FIG. 32 is a cross-sectional view illustrating a display device according to a second embodiment.
FIG. 33 is a cross-sectional view illustrating a semiconductor light emitting element according to a tenth embodiment.
FIG. 34 is a cross-sectional view illustrating a semiconductor light emitting element according to an eleventh embodiment.
FIG. 35 is a cross-sectional view illustrating a semiconductor light emitting element according to a twelfth embodiment.
FIG. 36 is a cross-sectional view illustrating a semiconductor light emitting element according to a thirteenth embodiment.
FIG. 37 is a cross-sectional view illustrating a semiconductor light emitting element according to a fourteenth embodiment.

The sizes, shapes, dimensions, etc. of elements illustrated in the drawings may differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

The display device described in this specification may comprise a TV, a signage, a mobile terminal such as a mobile phone or a smart phone, a computer display such as a laptop or a desktop, a head-up display (HUD) for an automobile, a backlight unit for display, display for VR, AR, or mixed reality (MR), a light source, etc. However, the configuration according to the embodiment described in this specification may be equally applied to a device capable of displaying, even if it is a new product type developed in the future.

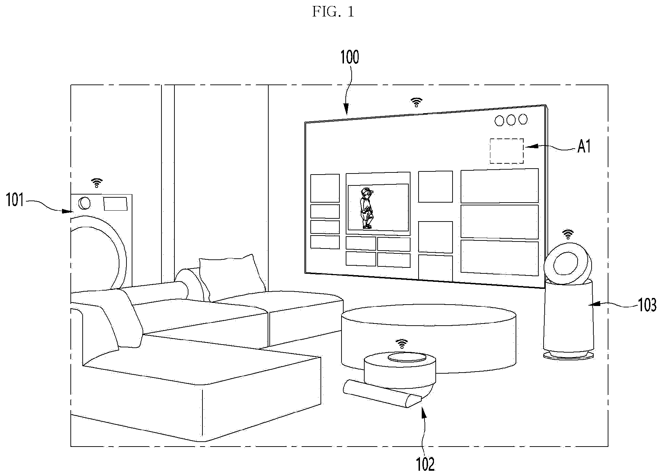

FIG. 1 illustrates a living room of a house in which a display device according to an embodiment is disposed.

Referring to FIG. 1, the display device 100 according to the embodiment may display the status of various electronic products such as a washing machine 101, a robot vacuum cleaner 102, and an air purifier 103, and may communicate with each electronic product based on IoT and control each electronic product based on the user's setting data.

The display device 100 according to the embodiment may comprise a flexible display manufactured on a thin and flexible substrate. The flexible display may be bent or rolled like paper while maintaining the characteristics of a conventional flat display.

In the flexible display, visual information may be implemented by independently controlling the light emission of unit pixels disposed in a matrix form. A unit pixel means a minimum unit for implementing one color. The unit pixel of the flexible display may be implemented by a light emitting element. In the embodiment, the light emitting element may be a micro-LED or a nano-LED, but is not limited thereto.

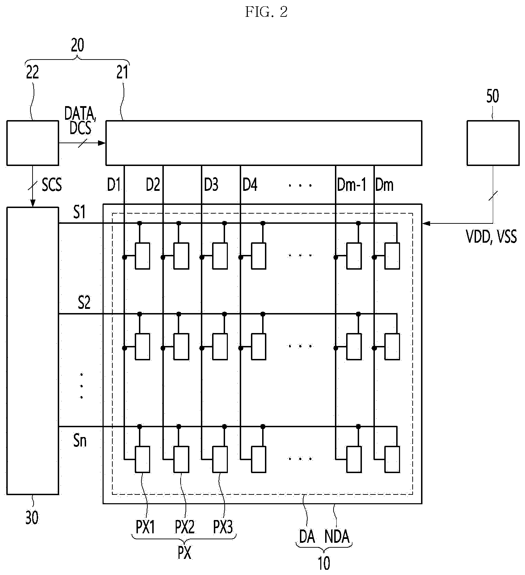

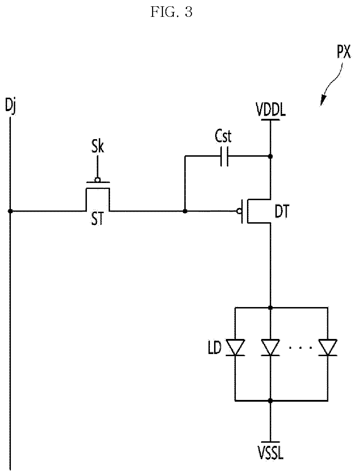

FIG. 2 is a block diagram schematically showing a display device according to an embodiment, and FIG. 3 is a circuit diagram showing an example of a pixel of FIG. 2.

Referring to FIG. 2 and FIG. 3, the display device according to an embodiment may comprise a display panel 10, a driving circuit 20, a scan driving unit 30, and a power supply circuit 50.

The display device 100 of the embodiment may drive a light emitting element in an active matrix (AM) method or a passive matrix (PM) method.

The driving circuit 20 may comprise a data driving unit 21 and a timing control unit 22.

The display panel 10 may be formed in a rectangular shape, but is not limited thereto. That is, the display panel 10 may be formed in a circular or oval shape. At least one side of the display panel 10 may be formed to be bent at a predetermined curvature.

The display panel may comprise a display region DA. The display region DA is a region where pixels PX are formed to display an image. The display panel may comprise a non-display region NDA. The non-display region NDA may be a region excluding the display region DA.

As an example, the display region DA and the non-display region NDA may be defined on the same surface. For example, the non-display region NDA may surround the display region DA on the same surface together with the display region DA, but is not limited thereto.

As another example, although not illustrated in the drawing, the display region DA and the non-display region NDA may be defined on different surfaces. For example, the display region DA may be defined on an upper surface of the substrate, and the non-display region NDA may be defined on a lower surface of the substrate. For example, the non-display region NDA may be defined on an entire region or a part of the lower surface of the substrate.

Meanwhile, although the drawing illustrates that the display region DA and the non-display region NDA are distinguished, the display region DA and the non-display region NDA may not be distinguished. That is, only the display region DA may exist on the upper surface of the substrate, and the non-display region NDA may not exist. In other words, the entire region of the upper surface of the substrate may be the display region DA where the image is displayed, and a bezel region, which is the non-display region NDA, may not exist.

The display panel 10 may comprise data lines (D1 to Dm, where m is an integer greater than or equal to 2), scan lines (S1 to Sn, where n is an integer greater than or equal to 2) intersecting the data lines D1 to Dm, a high-potential voltage line VDDL supplied with a high-potential voltage VDD, a low-potential voltage line VSSL supplied with a low-potential voltage VSS, and pixels PX connected to the data lines D1 to Dm and the scan lines S1 to Sn.

Each of the pixels PX may comprise a first subpixel PX1, a second subpixel PX2, and a third subpixel PX3. The first subpixel PX1 may emit a first color light of a first main wavelength, the second subpixel PX2 may emit a second color light of a second main wavelength, and the third subpixel PX3 may emit a third color light of a third main wavelength. The first color light may be red light, the second color light may be green light, and the third color light may be blue light, but the present invention is not limited thereto. In addition, although FIG. 2 exemplifies that each of the pixels PX comprises three subpixels, the present invention is not limited thereto. That is, each of the pixels PX may comprise four or more subpixels.

Each of the first subpixel PX1, the second subpixel PX2, and the third subpixel PX3 may be connected to at least one of the data lines D1 to Dm, at least one of the scan lines S1 to Sn, and a high-potential voltage line VDDL. The first subpixel PX1 may comprise light emitting elements LD, a plurality of transistors for supplying current to the light emitting elements LD, and at least one capacitor Cst, as illustrated in FIG. 3.

Although not illustrated in the drawing, each of the first subpixel PX1, the second subpixel PX2, and the third subpixel PX3 may comprise only one light emitting element LD and at least one capacitor Cst.

Each of the light emitting elements LD may be a semiconductor light emitting diode comprising a first electrode, a plurality of conductivity type semiconductor layers, and a second electrode. Here, the first electrode may be an anode electrode, and the second electrode may be a cathode electrode, but is not limited thereto.

The light emitting element LD may be one of a lateral-type light emitting element, a flip-chip type light emitting element, and a vertical-type light emitting element.

The plurality of transistors may comprise a driving transistor DT for supplying current to the light emitting elements LD, and a scan transistor ST for supplying a data voltage to a gate electrode of the driving transistor DT, as illustrated in FIG. 3. The driving transistor DT may comprise a gate electrode connected to a source electrode of the scan transistor ST, a source electrode connected to a high-potential voltage line VDDL to which a high-potential voltage VDD is applied, and a drain electrode connected to the first electrodes of the light emitting elements LD. The scan transistor ST may comprise a gate electrode connected to a scan line (Sk, where k is an integer satisfying 1≤k≤n), a source electrode connected to a gate electrode of a driving transistor DT, and a drain electrode connected to a data line (Dj, where j is an integer satisfying 1≤j≤m).

A capacitor Cst is formed between the gate electrode and the source electrode of the driving transistor DT. The storage capacitor Cst charges a difference value between the gate voltage and the source voltage of the driving transistor DT.

The driving transistor DT and the scan transistor ST may be formed as thin film transistors. In addition, although FIG. 3 mainly describes the driving transistor DT and the scan transistor ST formed as P-type metal oxide semiconductor field effect transistors (MOSFETs), the present invention is not limited thereto. The driving transistor DT and the scan transistor ST may also be formed as N-type MOSFETs. In this instance, the positions of the source electrode and the drain electrode of each of the driving transistor DT and the scan transistors ST may be changed.

In addition, in FIG. 3, the first subpixel PX1, the second subpixel PX2, and the third subpixel PX3 each comprise 2T1C (2 Transistor - 1 capacitor) having one driving transistor DT, one scan transistor ST, and one capacitor Cst, but the present invention is not limited thereto. The first subpixel PX1, the second subpixel PX2, and the third subpixel PX3 each may comprise a plurality of scan transistors ST and a plurality of capacitors Cst.

Since the second subpixel PX2 and the third subpixel PX3 may be expressed in substantially the same circuit diagram as the first subpixel PX1, detailed descriptions thereof will be omitted.

The driving circuit 20 outputs signals and voltages for driving the display panel 10. To this end, the driving circuit 20 may comprise a data driving unit 21 and a timing control unit 22.

The data driving unit 21 receives digital video data and a source control signal DCS from the timing control unit 22. The data driving unit 21 converts the digital video data into analog data voltages according to the source control signal DCS and supplies the converted data voltages to the data lines D1 to Dm of the display panel 10.

The timing control unit 22 receives digital video data and timing signals from the host system. The host system may be an application processor of a smartphone or tablet PC, a monitor, a system on chip of a TV, etc.

The timing control unit 22 generates control signals for controlling an operation timing of the data driving unit 21 and the scan driving unit 30. The control signals may comprise a source control signal DCS for controlling an operation timing of the data driving unit 21 and a scan control signal SCS for controlling an operation timing of the scan driving unit 30.

The driving circuit 20 may be disposed in a non-display region NDA provided on one side of the display panel 10. The driving circuit 20 may be formed as an integrated circuit (IC) and mounted on the display panel 10 using a chip on glass (COG) method, a chip on plastic (COP) method, or an ultrasonic bonding method, but the present invention is not limited thereto. For example, the driving circuit 20 may be mounted on a circuit board (not illustrated) other than the display panel 10.

The data driving unit 21 may be mounted on the display panel 10 using a chip on glass (COG) method, a chip on plastic (COP) method, or an ultrasonic bonding method, and the timing control unit 22 may be mounted on the circuit board.

The scan driving unit 30 receives a scan control signal SCS from the timing control unit 22. The scan driving unit 30 generates scan signals according to the scan control signal SCS and supplies them to scan lines S1 to Sn of the display panel 10. The scan driving unit 30 may be formed in the non-display region NDA of the display panel 10 and may comprise plurality of transistors. Alternatively, the scan driving unit 30 may be formed as an integrated circuit, in which case it may be mounted on a gate flexible film attached to another side of the display panel 10.

The power supply circuit 50 may generate voltages required for driving the display panel 10 from the main power applied from the system board and supply them to the display panel 10. For example, the power supply circuit 50 may generate a high-potential voltage VDD and a low-potential voltage VSS for driving the light emitting elements LD of the display panel 10 from the main power and supply them to the high-potential voltage line VDDL and the low-potential voltage line VSSL of the display panel 10. In addition, the power supply circuit 50 may generate and supply driving voltages for driving the driving circuit 20 and the scan driving unit 30 from the main power.

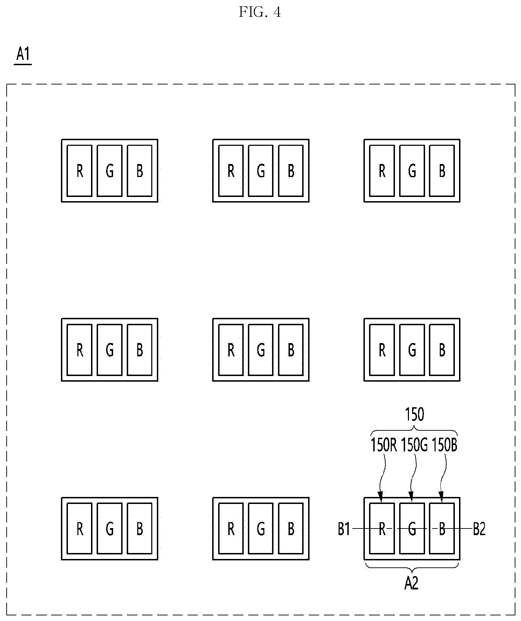

FIG. 4 is an enlarged view of a first panel region of the display device of FIG. 1.

Referring to FIG. 4, the display device 100 of the embodiment may be manufactured by mechanically and electrically connecting a plurality of panel regions such as the first panel region A1 by tiling.

The first panel region A1 may comprise a plurality of semiconductor light emitting elements 150 disposed for each unit pixel (PX of FIG. 2).

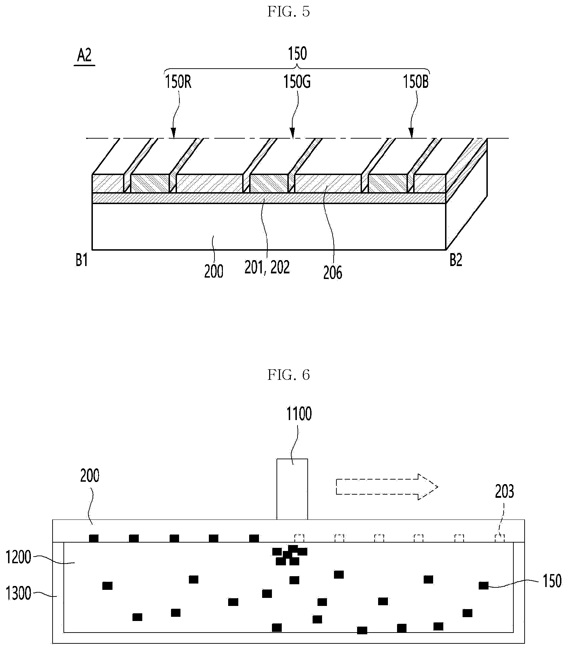

FIG. 5 is an enlarged view of a region A2 of FIG. 4.

Referring to FIG. 5, the display device 100 of the embodiment may comprise a substrate 200, assembly wirings 201 and 202, an insulating layer 206, and a plurality of semiconductor light emitting elements 150. More components may be included than these.

The assembly wirings may comprise a first assembly wiring 201 and a second assembly wiring 202 that are spaced apart from each other. The first assembly wiring 201 and the second assembly wiring 202 may be provided to generate a dielectrophoretic force (DEP force) to assemble the semiconductor light emitting elements 150. For example, the semiconductor light emitting element 150 may be one of a lateral-type semiconductor light emitting element, a flip-chip type semiconductor light emitting element, and a vertical-type semiconductor light emitting element.

The semiconductor light emitting elements 150 may comprise a red semiconductor light emitting element 150, a green semiconductor light emitting element 150G, and a blue semiconductor light emitting element 150B to form a unit pixel, but is not limited thereto, and red and green colors may be implemented by providing a red phosphor and a green phosphor.

The substrate 200 may be a support member that supports components disposed on the substrate 200 or a protective member that protects the components.

The substrate 200 may be a rigid substrate or a flexible substrate. The substrate 200 may be formed of sapphire, glass, silicon, or polyimide. In addition, the substrate 200 may comprise a flexible material such as polyethylene naphthalate (PEN), polyethylene terephthalate (PET). In addition, the substrate 200 may be a transparent material, but is not limited thereto. The substrate 200 may function as a supporting substrate in a display panel, and may also function as an assembly substrate when self-assembling a light emitting element.

The substrate 200 may be a backplane equipped with circuits, such as transistors ST and DT, capacitors Cst, and signal wiring, within the subpixels PX1, PX2, and PX3 illustrated in FIGS. 2 and 3, but is not limited thereto.

The insulating layer 206 may comprise an organic material having insulation and flexibility, such as polyimide, PAC, PEN, PET, polymer, or an inorganic material such as silicon oxide (SiO₂) or silicon nitride series (SiNx), and may be formed integrally with the substrate 200 to form a single substrate.

The insulating layer 206 may be a conductive adhesive layer having adhesion and conductivity, and the conductive adhesive layer may have flexibility to enable a flexible function of the display device. For example, the insulating layer 206 may be a conductive adhesive layer such as an anisotropic conductive film (ACF) or an anisotropic conductive medium, a solution containing conductive particles, etc. The conductive adhesive layer may be a layer that is electrically conductive in a direction vertical to the thickness, or electrically insulating in a direction horizontal to the thickness.

The insulating layer 206 may comprise an assembly hole 203 for inserting a semiconductor light emitting element 150. Therefore, when self-assembling, the semiconductor light emitting element 150 may be easily inserted into the assembly hole 203 of the insulating layer 206. The assembly hole 203 may be called an insertion hole, a fixing hole, an alignment hole, etc. The assembly hole 203 may also be called a hole.

The assembly hole 203 may be called a hole, a groove, a recess, a pocket, etc.

The assembly holes 203 may be different depending on the shapes of the semiconductor light emitting elements 150. For example, a red semiconductor light emitting element, a green semiconductor light emitting element, and a blue semiconductor light emitting element each have different shapes, and the shapes corresponding to the shapes of these semiconductor light emitting elements may be provided. For example, the assembly hole 203 may comprise a first assembly hole for assembling the red semiconductor light emitting element, a second assembly hole for assembling the green semiconductor light emitting element, and a third assembly hole for assembling the blue semiconductor light emitting element. For example, the red semiconductor light emitting element may have a circular shape, the green semiconductor light emitting element may have a first oval shape having a first minor axis and a first major axis, and the blue semiconductor light emitting element may have a second oval shape having a second minor axis and a second major axis, but is not limited thereto. The second major axis of the oval shape of the blue semiconductor light emitting element may be larger than the first major axis of the oval shape of the green semiconductor light emitting element, and the second minor axis of the oval shape of the blue semiconductor light emitting element may be smaller than the first minor axis of the oval shape of the green semiconductor light emitting element.

Meanwhile, the method of mounting the semiconductor light emitting element 150 on the substrate 200 may comprise, for example, a self-assembly method (FIG. 6) and a transfer method.

FIG. 6 is a drawing illustrating an example of a light emitting element according to an embodiment being assembled on a substrate by a self-assembly method.

Based on FIG. 6, an example in which a semiconductor light emitting element according to an embodiment is assembled on a display panel by a self-assembly method using an electromagnetic field will be described.

The assembly substrate 200 described below may also function as a panel substrate in a display device after assembling the light emitting element, but the embodiment is not limited thereto.

Referring to FIG. 6, the semiconductor light emitting element 150 may be put into a chamber 1300 filled with a fluid 1200, and the semiconductor light emitting element 150 may be moved to the assembly substrate 200 by a magnetic field generated from the assembly device 1100. At this time, the semiconductor light emitting element 150 adjacent to the assembly hole 207H of the assembly substrate 200 may be assembled into the assembly hole 207H by the DEP force caused by the electric field of the assembly wirings. The fluid 1200 may be water such as ultrapure water, but is not limited thereto. The chamber may be called a tank, a container, a vessel, etc.

After the semiconductor light emitting element 150 is put into in the chamber 1300, the assembly substrate 200 may be disposed on the chamber 1300. According to an embodiment, the assembly substrate 200 may be put into the chamber 1300.

The semiconductor light emitting element 150 may be implemented as a vertical-type semiconductor light emitting element as illustrated, but is not limited thereto, and a lateral-type light emitting element may be employed.

The semiconductor light emitting element 150 may comprise a magnetic layer (not illustrated) having a magnetic substance. The magnetic layer may comprise a metal having magnetism, such as nickel (Ni). Since the semiconductor light emitting element 150 put into the fluid comprises the magnetic layer, it may move to the assembly substrate 200 by a magnetic field generated from the assembly device 1100. The magnetic layer may be disposed on the upper side, the lower side or both sides of the light emitting element.

Meanwhile, the first assembly wiring 201 and the second assembly wiring 202 form an electric field as an AC voltage is applied, and the semiconductor light emitting element 150 put into the assembly hole 207H may be fixed by the DEP force caused by the electric field. The gap between the first assembly wiring 201 and the second assembly wiring 202 may be smaller than the width of the semiconductor light emitting element 150 and the width of the assembly hole 207H, and the assembly position of the semiconductor light emitting element 150 can be fixed more precisely using the electric field.

An insulating layer 215 is formed on the first assembly wiring 201 and the second assembly wiring 202 to protect the first assembly wiring 201 and the second assembly wiring 202 from the fluid 1200 and prevent leakage of current flowing in the first assembly wiring 201 and the second assembly wiring 202. For example, the insulating layer 215 may be formed of a single layer or multiple layers of an inorganic insulator such as silica or alumina, or an organic insulator. The insulating layer 215 may have a minimum thickness to prevent damage to the first assembly wiring 201 and the second assembly wiring 202 during assembly of the semiconductor light emitting element 150, and may have a maximum thickness to stably assemble the semiconductor light emitting element 150.

A partition wall 207 may be formed on an upper part of the insulating layer 215. A part of the partition wall 207 may be positioned on an upper part of the first assembly wiring 201 and the second assembly wiring 202, and the remaining regions may be positioned on the upper part of the assembly substrate 200.

Meanwhile, when manufacturing the assembly substrate 200, a part of the partition wall formed on the upper part of the insulating layer 215 may be removed, thereby forming an assembly hole 207H in which each of the semiconductor light emitting elements 150 is coupled and assembled to the assembly substrate 200.

An assembly hole 207H is formed in the assembly substrate 200, into which semiconductor light emitting elements 150 are combined, and a surface on which the assembly hole 207H is formed may be in contact with a fluid 1200. The assembly hole 207H may guide an accurate assembly position of the semiconductor light emitting element 150.

Meanwhile, the assembly hole 207H may have a shape and size corresponding to the shape of the semiconductor light emitting element 150 to be assembled at a corresponding position. Accordingly, another semiconductor light emitting element may be assembled in the assembly hole 207H or a plurality of semiconductor light emitting elements may be prevented from being assembled.

Referring again to FIG. 6, after the assembly substrate 200 is disposed in the chamber, an assembly device 1100 that applies a magnetic field may move along the assembly substrate 200. The assembly device 1100 may be a permanent magnet or an electromagnet.

The assembly device 1100 may move in contact with the assembly substrate 200 to maximize a region affected by the magnetic field within the fluid 1200. Depending on the embodiment, the assembly device 1100 may comprise a plurality of magnetic substances or may comprise a magnetic substance of a size corresponding to the assembly substrate 200. In this instance, the movement distance of the assembly device 1100 may be limited within a predetermined range.

The semiconductor light emitting element 150 within the chamber 1300 may move toward the assembly device 1100 and the assembly substrate 200 by the magnetic field generated by the assembly device 1100.

The semiconductor light emitting element 150 may enter the assembly hole 207H and be fixed by the DEP force formed by the electric field between the assembly wirings 201 and 202 while moving toward the assembly device 1100.

Specifically, the first and second assembly wirings 201 and 202 form an electric field by an AC power source, and a DEP force may be formed between the assembly wirings 201 and 202 by this electric field. The semiconductor light emitting element 150 may be fixed to the assembly hole 207H on the assembly substrate 200 by this DEP force.

At this time, a predetermined solder layer (not illustrated) is formed between the semiconductor light emitting element 150 assembled on the assembly hole 207H of the assembly substrate 200 and the assembly wirings 201 and 202, so that the binding force of the semiconductor light emitting element 150 can be improved.

In addition, a molding layer (not illustrated) may be formed on the assembly hole 207H of the assembly substrate 200 after assembly. The molding layer may be a transparent resin or a resin containing a reflective material or a scattering material.

Since the time required for each semiconductor light emitting element to be assembled on a substrate may be drastically shortened by the self-assembly method using the electromagnetic field described above, a large-area, high-pixel display may be implemented more quickly and economically.

Hereinafter, various embodiments for solving the above-described problem will be described with reference to FIGS. 7 to 37. Any explanation omitted below may be easily understood from the explanation given above in relation to FIGS. 1 to 6 and the corresponding drawings.

The semiconductor light emitting element described below may have a size of micrometers or less. As described above, as the size of the semiconductor light emitting element decreases, there is a problem that the light luminance decreases. Various embodiments that may improve the light luminance are described below.

In addition, the semiconductor light emitting element described below may be a vertical-type semiconductor light emitting element in which current flows vertically.

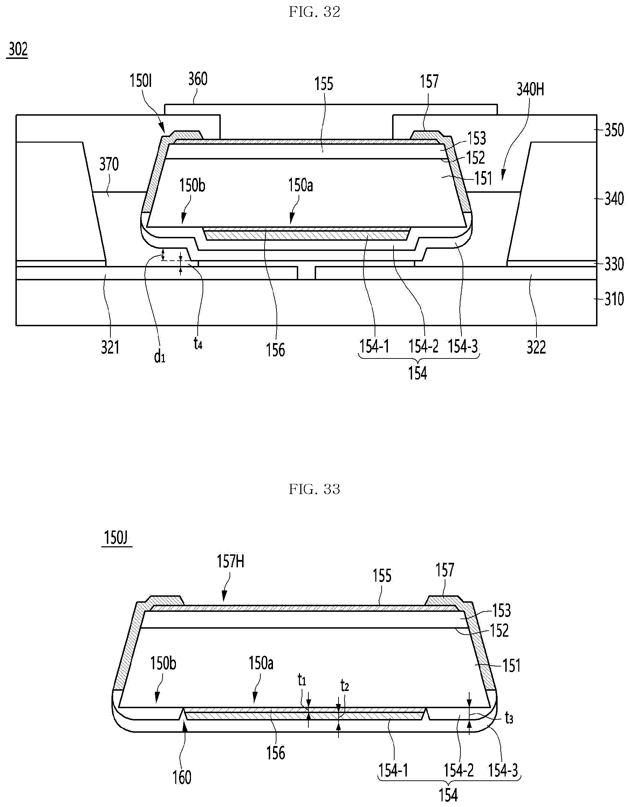

In addition, in the description below, when there is no corresponding drawing or the corresponding component is not illustrated, the component illustrated in FIG. 21 or 32 or the drawing symbol thereof will be referred to.

### [First Embodiment]

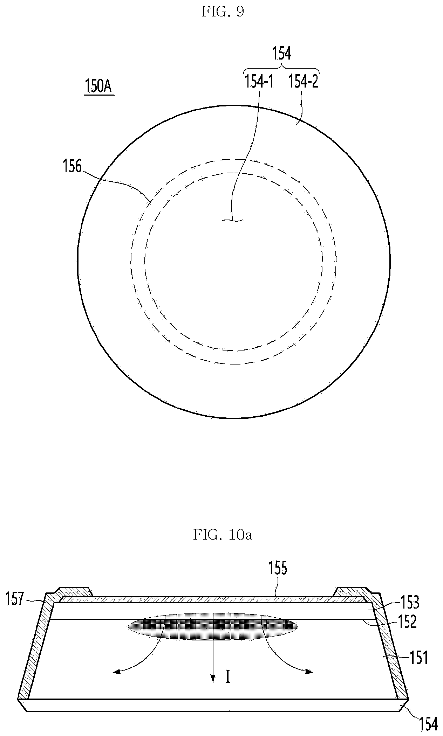

FIG. 7 is a cross-sectional view illustrating a semiconductor light emitting element according to a first embodiment. FIG. 8 is a plan view illustrating a semiconductor light emitting element according to the first embodiment. FIG. 9 is a bottom view illustrating a semiconductor light emitting element according to the first embodiment.

Referring to FIGS. 7 to 9, the semiconductor light emitting element 150A according to the first embodiment may comprise a light emitting layer 151 to 153, a passivation layer 157, an insulating layer 156, a first electrode 154, and a second electrode 155.

The light emitting layer 151 to 153 may emit light of a specific color. The specific color light may be determined by a semiconductor material of the light emitting layer 151 to 153. The specific color light may be, for example, red light, green light, or blue light. Hereinafter, the light emitting layer 151 to 153 will be described as emitting red light, but the light emitting layer 151 to 153 of the embodiment may emit green light or blue light.

The light emitting layer 151 to 153 may comprise a plurality of semiconductor layers. For example, the light emitting layer 151 to 153 may comprise at least one or more first conductivity type semiconductor layer 151, an active layer 152, and at least one or more second conductivity type semiconductor layer 153. The active layer 152 may be disposed on the first conductivity type semiconductor layer 151, and the second conductivity type semiconductor layer 153 may be disposed on the active layer 152. The first conductivity type semiconductor layer 151 may comprise an n-type dopant, and the second conductivity type semiconductor layer 153 may comprise a p-type dopant, but is not limited thereto.

The light emitting layer 151 to 153 may have a first region 150a and a second region 150b surrounding the first region 150a.

The passivation layer 157 may be made of a material having excellent insulating properties, and may protect the light emitting layer 151 to 153 and prevent leakage current flowing in a lateral part of the light emitting layer 151 to 153.

The passivation layer 157 may surround the lateral part of the light emitting layer 151 to 153. The passivation layer 157 may be disposed in an edge region of the light emitting layer 151 to 153. The passivation layer 157 may have an opening 157H corresponding to a center region of the light emitting layer 151 to 153. For example, after the passivation layer 157 may be formed on an upper surface of the second electrode 155, the passivation layer 157 corresponding to the central region of the light emitting layer 151 to 153 may be removed, so that an opening 157H corresponding to the central region of the light emitting layer 151 to 153 may be formed, and the passivation layer 157 may be formed on the second electrode 155 corresponding to the edge region of the light emitting layer 151 to 153. The central region may correspond to the first region 150a, and the edge region may correspond to the second region 150b, but is not limited thereto.

The insulating layer 156 may be disposed under the first region 150a of the light emitting layer 151 to 153. The insulating layer may be a current blocking layer and may obtain a current spreading effect. To this end, the insulating layer 156 may have a shape corresponding to the shape of the opening 157H formed in the passivation layer 157. For example, when the opening 157H is circular, the insulating layer 156 may also have a circular shape. At this time, the width (or diameter) of the insulating layer 156 may be the same as the width (or diameter) of the opening 157H, but is not limited thereto. As will be described later, the electrode wiring (360 of FIG. 21) may be connected to the second electrode 155 through the opening 157H. In this instance, the width (or diameter) of the electrode wiring 360 formed in the opening 157H may be the same as or smaller than the width (or diameter) of the insulating layer 156, but is not limited thereto.

As illustrated in FIG. 10A, when the first electrode 154 and the second electrode 155 are disposed in the entire regions of the lower and upper sides of the light emitting layer 151 to 153, current crowding may occur in which current I is concentrated in the first region 150a of the light emitting layer 151 to 153. In this instance, the current I does not flow in the second region 150b of the light emitting layer 151 to 153, i.e., the edge region of the active layer 152, so that light is not generated, and thus the luminous efficiency may be reduced.

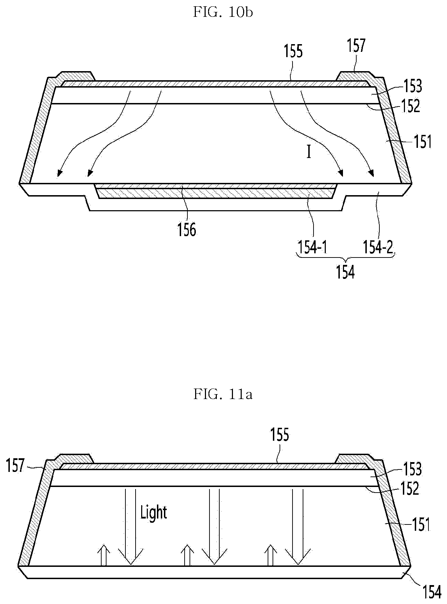

As in the embodiment, the insulating layer 156 may be disposed between the light emitting layer 151 to 153 and the first electrode 154, but may be disposed under the first region 150a of the light emitting layer 151 to 153. That is, an upper surface of the insulating layer 156 may be in contact with the first region 150a of the light emitting layer 151 to 153, and an upper surface of the first electrode 154 may be in contact with the second region 150b of the light emitting layer 151 to 153. In this instance, as illustrated in FIG. 10B, since the current I flows not only in the first region 150a of the light emitting layer 151 to 153 but also in the second region 150b, light may be generated in the entire region of the active layer 152, so that luminous efficiency can be improved and, accordingly, light luminance can be improved.

The insulating layer 156 may be used as an ODR together with the reflective layer 154-1 of the first electrode 154. Compared to a distributed bragg reflector (DBR), the ODR has the advantage of high reflectivity over a wide wavelength range and a wide incident angle, as well as a simple manufacturing process.

For ODR, the refractive index of the insulating layer 156 may have a refractive index lower than the refractive index of the light emitting layer 151 to 153, for example, the refractive index of the first conductivity type semiconductor layer 151. Accordingly, the insulating layer 156 may be called a low refractive index layer. The first conductivity type semiconductor layer 151 of the light emitting layer 151 to 153 may be called a high refractive index layer. For example, Al(Ga)InP may be used as the first conductivity type semiconductor layer 151 in the light emitting layer 151 to 153 that emit red light, and the refractive index of the Al(Ga)InP may be 3.4 to 3.5.

In this instance, the refractive index of the insulating layer 156 may be less than 3.4. For example, the insulating layer 156 may comprise SiO₂, SiON, SiNx, Si₃N₄, MgF₂, TiO₂, Ta₃O₄, Al₂O₃, ZnS, etc. Meanwhile, a thickness t₁ of the insulating layer 156 may be λ/4n.

FIG. 11A illustrates light reflection in a semiconductor light emitting element according to a comparative example.

As illustrated in FIG. 11A, when the insulating layer 156 is not provided and the first electrode 154 is provided, the reflectivity may be reduced.

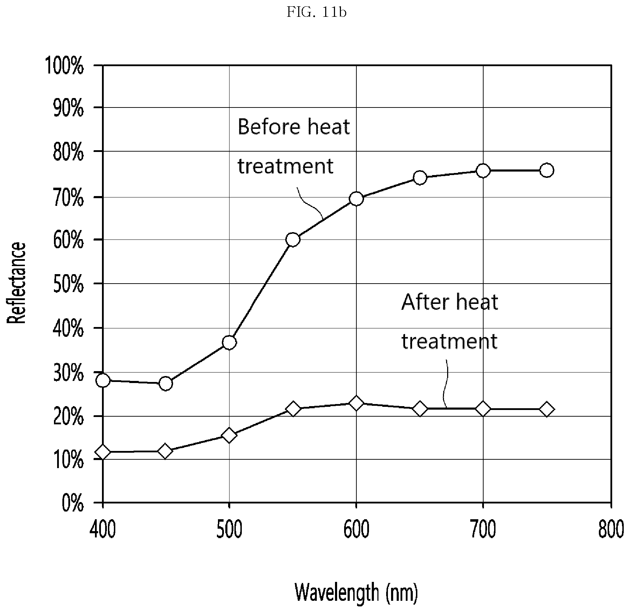

In particular, heat treatment must be performed to form the ohmic contact layer 154-2 included in the first electrode 154. As illustrated in FIG. 11B, before the heat treatment of the ohmic contact layer 154-2, the reflectivity is 70% to 80% in a range of 600 nm or more in wavelength, whereas after the heat treatment of the ohmic contact layer 154-2, the reflectivity may be 20% in a range of 600 nm or more in wavelength. Accordingly, since the light generated in the active layer 152 of the semiconductor light emitting element is not reflected by the first electrode 154 but is mostly absorbed, a problem occurs in which luminous efficiency is reduced.

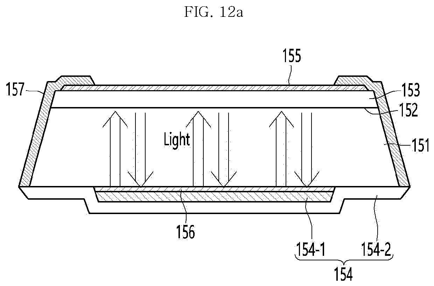

In contrast, as illustrated in FIG. 12A, when an insulating layer 156 having a refractive index lower than that of the light emitting layer 151 to 153 is disposed between the light emitting layer 151 to 153 and the first electrode 154, the reflectivity can be increased.

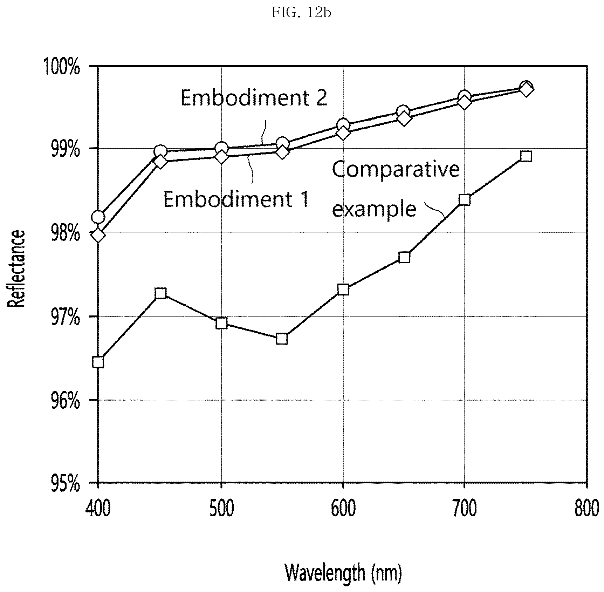

As illustrated in FIG. 12B, the comparative example is provided with only a reflection layer 154-1 made of silver (Ag), the embodiment 1 is provided with an insulating layer 156 made of SiO₂ on the reflection layer 154-1 made of silver (Ag), and the embodiment 2 may be provided with an insulating layer 156 made of MgF₂ on the reflection layer 154-1 made of silver (Ag). The refractive index of SiO₂ may be 1.46, and the refractive index of MgF₂ may be 1.38.

In 650 nm which is the wavelength band of red light, each of the embodiments 1 and 2 may have a reflectivity improvement of about 2% compared to the comparative example.

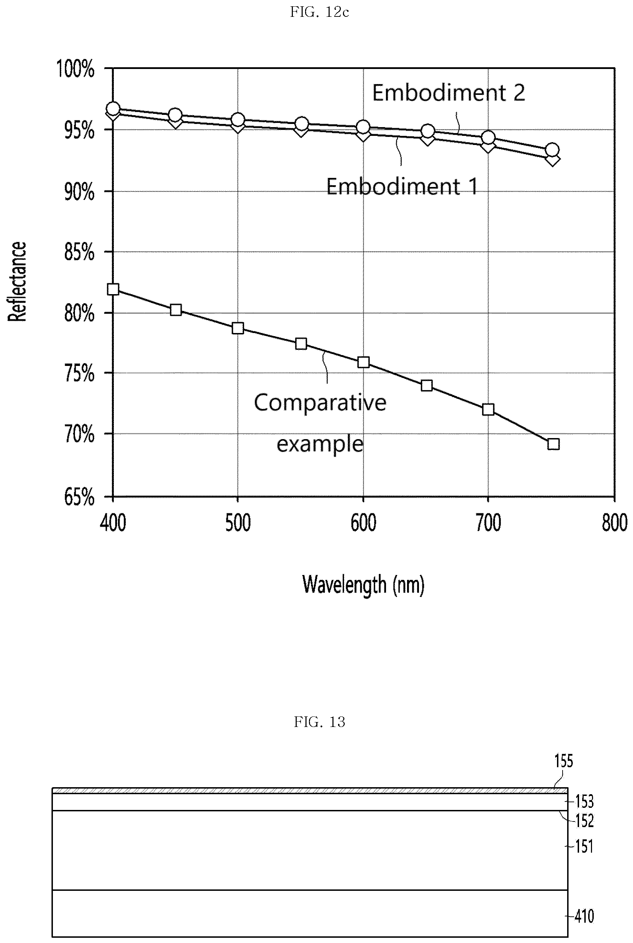

As illustrated in FIG. 12C, the comparative example may be provided with only a reflection layer 154-1 made of aluminum (Al), the exemplary embodiment may be provided with an insulating layer 156 made of SiO₂ on the reflection layer 154-1 made of aluminum (Al), and the exemplary embodiment 2 may be provided with an insulating layer 156 made of MgF₂ on the reflection layer 154-1 made of aluminum (Al).

In 650 nm which is the wavelength band of red light, each of the exemplary embodiments 1 and 2 may have a reflectivity improved by about 20% compared to the comparative example.

From this, the lower the refractive index of the insulating layer 156, the higher the reflectivity. In addition, it may be seen that the reflectivity is further increased when aluminum (Al) is used rather than silver (Ag) as the reflection layer 154-1, and MgF₂ is used rather than SiO₂ as the insulating layer 156.

Meanwhile, the first electrode 154 may be disposed under the light emitting layer 151 to 153. A part of the first electrode 154 may be disposed under the insulating layer 156.

The first electrode 154 may comprise a reflective layer 154-1 and an ohmic contact layer 154-2. As described above, the reflective layer 154-1 may form an ODR together with the insulating layer 156. The reflective layer 154-1 may form an ODR together with the insulating layer 156 and the first conductivity type semiconductor layer 151 of the light emitting layer 151 to 153.

The reflective layer 154-1 may be disposed under the light emitting layer 151 to 153. The reflective layer 154-1 may be disposed under the insulating layer 156. The reflective layer 154-1 may have a function of reflecting light. The reflective layer 154-1 may be made of a metal. For example, the reflective layer 154-1 may comprise silver (Ag), aluminum (Al), gold (Au), etc.

For example, the reflective layer 154-1 may have a shape corresponding to the shape of the insulating layer 156. As illustrated in FIG. 9, when the light emitting layer 151 to 153 have a circular shape, the insulating layer 156 and the reflective layer 154-1 may each have a circular shape. For example, the insulating layer 156 and the reflective layer 154-1 may be disposed under the first region 150a of the light emitting layer 151 to 153. The size of the reflective layer 154-1 may be smaller than the size of the insulating layer 156, but is not limited thereto. For example, the size of the reflective layer 154-1 may be the same as the size of the insulating layer 156. In this instance, a lateral surface of the reflective layer 154-1 and a lateral surface of the insulating layer 156 may coincide with a vertical direction.

Light generated in the light emitting layer 151 to 153 may be refracted at a boundary between the first conductivity type semiconductor layer 151 and the insulating layer 156 due to the difference in refractive index between the first conductivity type semiconductor layer 151 and the insulating layer 156. The refracted light may be reflected by the reflective layer 154-1 via the insulating layer 156 and then refracted again at the boundary between the insulating layer 156 and the first conductivity type semiconductor layer 151. Accordingly, the light may be refracted at a wider beam angle by the insulating layer 156 and reflected without absorption by the reflective layer 154-1, so that the luminous efficiency can be improved and ultimately the light luminance can be improved.

Therefore, according to the first embodiment, by obtaining a light spreading effect by the insulating layer 156 and configuring an ODR together with the reflective layer 154-1, the luminous efficiency and the light luminance can be significantly improved.

The ohmic contact layer 154-2 may be disposed under the light emitting layer 151 to 153. The ohmic contact layer 154-2 may be disposed under the second region 150b of the light emitting layer 151 to 153. The ohmic contact layer 154-2 may be in contact with a lower surface of the second region 150b of the light emitting layer 151 to 153, for example, a lower surface of the first conductivity type semiconductor layer 151.

In addition, the ohmic contact layer 154-2 may be disposed under the first region 150a of the light emitting layer 151 to 153. The ohmic contact layer 154-2 may be disposed under the insulating layer 156. For example, the ohmic contact layer 154-2 may be in contact with the lower surface of the insulating layer 156.

In addition, the ohmic contact layer 154-2 may surround the insulating layer 156. The ohmic contact layer 154-2 may be disposed along the perimeter of a lateral part of the insulating layer 156. The ohmic contact layer 154-2 may surround the reflective layer 154-1. The ohmic contact layer 154-2 may be disposed along the perimeter of a lateral part of the reflective layer 154-1. The ohmic contact layer 154-2 may be disposed on the lower surface of the reflective layer 154-1.

The ohmic contact layer 154-2 may be formed to improve the ohmic characteristics with respect to the first conductivity type semiconductor layer 151. The ohmic contact layer 154-2 may comprise Au, AuBe, AuGe, etc.

Meanwhile, since the insulating layer 156 and the reflective layer 154-1 are disposed under the first region 150a of the light emitting layer 151 to 153, the insulating layer 156 and the reflective layer 154-1 may protrude downward from the lower surface of the first region 150a of the light emitting layer 151 to 153. In this instance, since the ohmic contact layer 154-2 is disposed under not only the first region 150a of the light emitting layer 151 to 153 but also the second region 150b and may be formed to surround the reflective layer 154-1, the ohmic contact layer 154-2 may have a step difference d₁. That is, the ohmic contact layer 154-2 may have a step difference d₁ under the first region 150a and the second region 150b. For example, the ohmic contact layer 154-2 under the first region 150a may protrude further downward than the ohmic contact layer 154-2 under the second region 150b. For example, the lower surface of the ohmic contact layer 154-2 under the second region 150b may be positioned the same as or higher than the lower surface of the reflective layer 154-1, whereas the lower surface of the ohmic contact layer 154-2 under the first region 150a may be positioned lower than the lower surface of the reflective layer 154-1. Here, the thickness of the ohmic contact layer 154-2 under the first region 150a and the thickness of the ohmic contact layer 154-2 under the second region 150b may be the same, but is not limited thereto.

In this way, a lower side of the semiconductor light emitting element 150A according to the first embodiment may have a non-uniform surface. That is, since the central region of the first electrode 154 disposed under the semiconductor light emitting element 150A according to the first embodiment protrudes downward, the problem of the semiconductor light emitting element being adsorbed on the bottom surface of the chamber or the upper surface of the display substrate in the fluid during self-assembly may be solved. That is, since the area of the semiconductor light emitting element 150A according to the first embodiment that comes into contact with the bottom surface of the chamber or the upper surface of the display substrate is reduced, the semiconductor light emitting element 150A may not be adsorbed on the bottom surface of the chamber or the upper surface of the display substrate. Accordingly, since more semiconductor light emitting elements participate in self-assembly on the display substrate, the assembly rate can be improved.

The second electrode 155 may be disposed on the light emitting layer 151 to 153. The second electrode 155 may be disposed on the first region 150a of the light emitting layer 151 to 153. The second electrode 155 may be disposed on the second region 150b of the light emitting layer 151 to 153. In the drawing, the width of the second electrode 155 is illustrated as being smaller than the width of the light emitting layer 151 to 153, and thus the second electrode 155 is not disposed on an entire region of the light emitting layer 151 to 153, but the second electrode 155 may be disposed on the entire region of the light emitting layer 151 to 153.

The second electrode 155 may be a transparent conductive layer and may comprise ITO, IZO, etc.

FIGS. 13 to 20 illustrate a manufacturing process of a semiconductor light emitting element according to the first embodiment.

As illustrated in FIG. 13, a plurality of semiconductor layers may be deposited on a growth substrate 410 using a deposition equipment such as an MOCVD equipment. The growth substrate 410 may be a wafer. In order to manufacture a semiconductor light emitting element that emits red light, the growth substrate 410 may be a GaAs substrate, but is not limited thereto. As described above, the plurality of semiconductor light emitting elements may comprise at least one or more first conductivity type semiconductor layer 151, an active layer 152, and at least one or more second conductivity type semiconductor layer 153. Although not illustrated, in order to facilitate the deposition of the plurality of semiconductor layers, an undoped semiconductor layer may be deposited on the growth substrate 410, and then the plurality of semiconductor layers may be deposited on the undoped semiconductor layer. The plurality of semiconductor layers may constitute the light emitting layer 151 to 153.

Thereafter, a second electrode 155 made of a transparent conductive material may be formed on the light emitting layer 151 to 153 using a sputtering device.

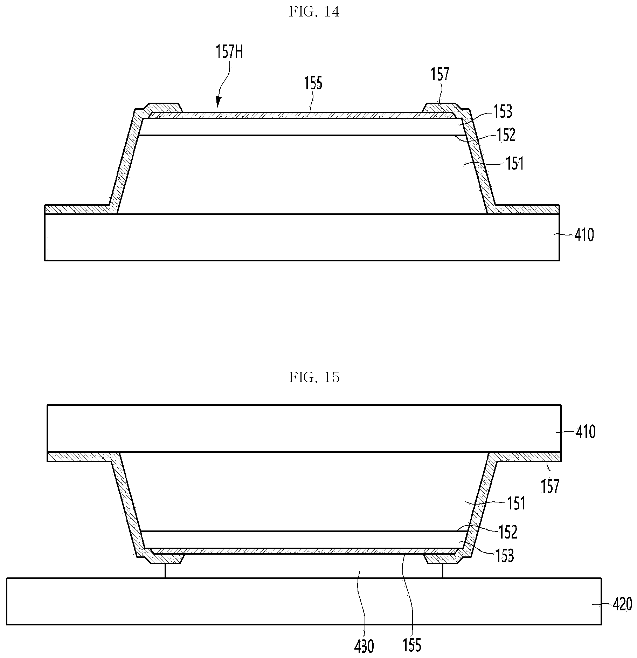

As illustrated in FIG. 14, the second electrode 155 and the light emitting layer 151 to 153 may be etched by performing an etching process, thereby separating the semiconductor light emitting elements on the growth substrate 410. That is, adjacent semiconductor light emitting elements may be spaced apart from each other. When the final process is performed, a plurality of semiconductor light emitting elements may be manufactured on the growth substrate 410.

The light emitting layer 151 to 153 may have different sizes on the lower and upper sides by mesa etching. For example, the size of the upper side of the light emitting layer 151 to 153 may be smaller than the size of the lower side of the light emitting layer 151 to 153. That is, by etching from the upper side to the lower side of the light emitting layer 151 to 153, the size of the light emitting layer 151 to 153 may gradually increase.

Thereafter, a passivation layer 157 may be formed on the growth substrate 410. That is, an insulating film may be applied over an entire region of the growth substrate 410. That is, the insulating film may be applied on the upper surface of the growth substrate 410 between the semiconductor light emitting elements, the lateral part of the light emitting layer 151 to 153, and the second electrode 155. The insulating film corresponding to the central region of the light emitting layer 151 to 153, that is, the first region 150a, may be removed to form an opening 157H. At this time, the remaining insulating film except for the opening 157H may become the passivation layer 157. The passivation layer 157 may be disposed on an edge region of the second electrode 155 and surround the light emitting layer 151 to 153.

As illustrated in FIG. 15, after the growth substrate 410 is turned over, the second electrode 155 may be bonded to a temporary substrate 420 using an adhesive layer 430. The temporary substrate 420 may be made of a material having high heat resistance and durability. The temporary substrate 420 may be, for example, a sapphire substrate, but is not limited thereto. The adhesive layer 430 may be made of a metal layer or a double structure of a metal layer and an insulating layer. For example, the metal layer may comprise aluminum (Al) that is easy to etch, but is not limited thereto. The insulating layer 156 may be made of an organic material, but is not limited thereto.

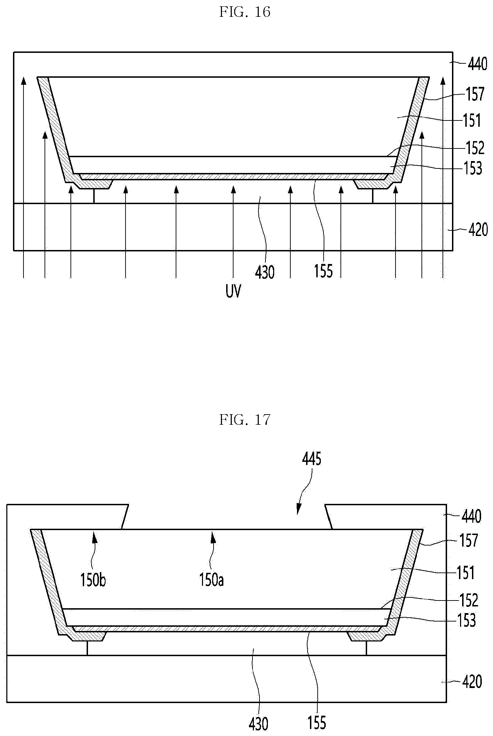

As illustrated in FIG. 16, after a photosensitive film 440 may be applied on a temporary substrate 420, a photolithography process may be performed. That is, light such as UV is irradiated from the rear of the temporary substrate 420 toward the temporary substrate 420, so that the light may penetrate the temporary substrate 420 and expose the photosensitive film 440. At this time, the light emitting layer 151 to 153 may be used as an exposure mask, so that the light cannot penetrate the light emitting layer 151 to 153 and is not transmitted onto the light emitting layer 151 to 153.

Thereafter, by performing the developing process, an opening 445 may be formed on the first region 150a of the light emitting layer 151 to 153, as illustrated in FIG. 17. That is, the upper surface of the first region 150a of the light emitting layer 151 to 153 may be exposed through the opening 445. The opening 445 may have a shape in which the width becomes narrower as it goes from the upper surface of the first region 150a of the light emitting layer 151 to 153 to an upper direction, but is not limited thereto.

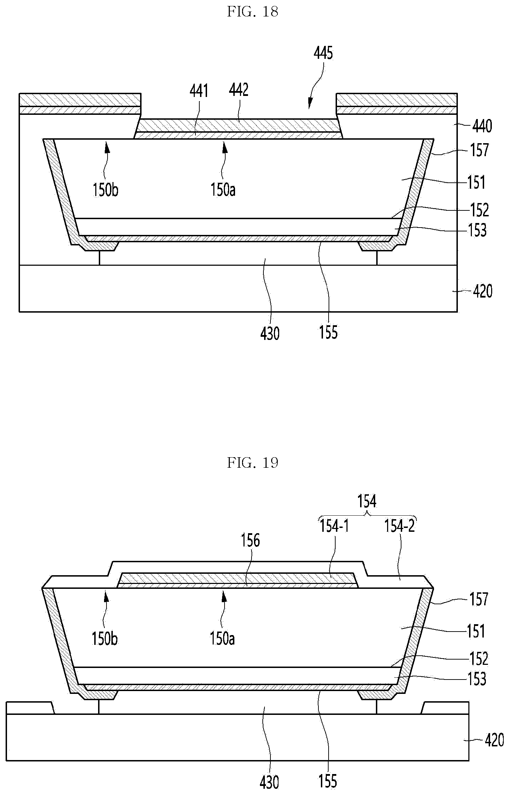

As illustrated in FIG. 18, an insulating layer 156 may be deposited on the photosensitive film 440, and then a reflective layer 154-1 may be deposited. Accordingly, the insulating layer 156 and the reflective layer 154-1 may be formed on the upper surface of the first region 150a of the light emitting layer 151 to 153 through the opening 445, and may also be formed on the upper surface of the photosensitive film 440.

Thereafter, a lift-off process may be performed, and as illustrated in FIG. 19, the photosensitive film 440 may be removed.

Thereafter, a metal film for an ohmic contact may be deposited on the substrate. A metal film for ohmic contact may be formed on the upper surface of the temporary substrate 420, the upper surface of the light emitting layer 151 to 153, the lateral surface of the insulating layer 156, and the upper surface and lateral surface of the reflective layer 154-1. The metal film for ohmic contact may surround the insulating layer 156 and the reflective layer 154-1. At this time, the metal film for ohmic contact may be in contact with the passivation layer 157 on the upper surface of the light emitting layer 151 to 153.

Thereafter, a heat treatment process may be performed to form ohmic characteristics, so that an ohmic contact layer 154-2 having excellent ohmic characteristics may be formed. A first electrode 154 may be formed by the ohmic contact layer 154-2 and the reflective layer 154-1. An ODR may be formed by the reflective layer 154-1 and the insulating layer 156.

As illustrated in FIG. 20, the etching process may be performed to remove the adhesive layer 430, so that a large number of semiconductor light emitting elements may be separated from the temporary substrate 420.

Through the manufacturing process described above, a plurality of semiconductor light emitting elements 150A according to the first embodiment may be manufactured at the wafer level. For example, millions of semiconductor light emitting elements may be manufactured on the growth substrate 410 (or wafer).

FIG. 21 is a cross-sectional view illustrating a display device according to a first embodiment.

Referring to FIG. 21, the display device 301 according to the first embodiment may comprise a backplane substrate, a semiconductor light emitting element, a connecting electrode 370, a second insulating layer 350, and electrode wiring 360.

The backplane substrate may be prepared in advance. Thereafter, the semiconductor light emitting element may be assembled into the assembly hole 340H of the backplane substrate using a self-assembly process. Thereafter, the display device 301 according to the first embodiment may be manufactured by forming the connecting electrode 370, the second insulating layer 350, and the electrode wiring 360 through the post-process.

The backplane substrate may comprise the substrate 310, the first assembly wiring 321, the second assembly wiring 322, the first insulating layer 330, and the partition wall 340.

The substrate 310 may be a support substrate for supporting components of the display device 301 according to the first embodiment, such as the semiconductor light emitting element, the connecting electrode 370, the second insulating layer 350, the electrode wiring 360, etc., and may be called a lower substrate or a display substrate. Although not illustrated, an upper substrate may be disposed on the electrode wiring 360, but is not limited thereto.

The first assembly wiring 321 may be disposed on the substrate 310. The second assembly wiring 322 may be disposed on the substrate 310.

For example, the first assembly wiring 321 and the second assembly wiring 322 may be disposed on the same layer, respectively. For example, the first and second assembly wirings 321 and 322 may be in contact with the upper surface of the substrate 310, but is not limited thereto. For example, the first assembly wiring 321 and the second assembly wiring 322 may be disposed on the same layer, respectively. For example, the first assembly wiring 321 and the second assembly wiring 322 may be disposed parallel to each other, respectively. The first assembly wiring 321 and the second assembly wiring 322 may play a role in assembling the semiconductor light emitting element 150A into the assembly hole 340H using a self-assembly method. That is, when self-assembling, an electric field may be generated between the first assembly wiring 321 and the second assembly wiring 322 by a voltage supplied to the first assembly wiring 321 and the second assembly wiring 322, and the semiconductor light emitting element 150A moving by the assembly device (1100 of FIG. 10) may be assembled into the assembly hole 340H by the DEP force formed by the electric field. The assembly hole 340H may have a diameter greater than the diameter of the semiconductor light emitting element 150A.

The first assembly wiring 321 and the second assembly wiring 322 may each comprise a plurality of metal layers. Although not illustrated, the first assembly wiring 321 and the second assembly wiring 322 may each comprise a main wiring and an auxiliary electrode. The main wiring of each of the first assembly wiring 321 and the second assembly wiring 322 may be disposed lengthwise along one direction of the substrate 310. The auxiliary electrodes of the first assembly wiring 321 and the second assembly wiring 322 may extend from the main wiring toward the assembly hole 340H. The auxiliary electrodes may be electrically connected to the main wiring. The main wiring may be disposed on the auxiliary wiring so that the lower surface of the main wiring may contact the upper surface of the auxiliary wiring, but is not limited thereto.

Meanwhile, although not illustrated, the first assembly wiring 321 and the second assembly wiring 322 may be disposed on different layers.

The first insulating layer 330 may be disposed on the first assembly wiring 321 and the second assembly wiring 322. For example, the first insulating layer 330 may be made of an inorganic material or an organic material. For example, the first insulating layer 330 may be made of a material having a permittivity related to the DEP force. For example, the higher the permittivity of the first insulating layer 330, the greater the DEP force, but is not limited thereto. The first insulating layer 330 may prevent the fluid from directly contacting the first assembly wiring 321 or the second assembly wiring 322 and corroding them by the assembly hole 340H of the partition wall 340 formed thereafter during self-assembly.

Although the drawing illustrates that the first insulating layer 330 is removed within the assembly hole 340H, the first insulating layer 330 may remain unremoved within the assembly hole 340H in the backplane substrate. The process of removing the first insulating layer 330 within the assembly hole 340H may be performed after the semiconductor light emitting element is assembled into the assembly hole 340H. The removal of the first insulating layer 330 within the assembly hole 340H is for the connecting electrode 370 to electrically connect with the first assembly wiring 321 and/or the second assembly wiring 322.

The partition wall 340 may be disposed on the first insulating layer 330. The partition wall 340 may have an assembly hole 340H. The assembly hole 340H may be formed in each of the plurality of subpixels of each of the plurality of pixels. That is, one assembly hole 340H may be formed per subpixel, but is not limited thereto. For example, the first insulating layer 330 may be exposed within the assembly hole 340H. For example, a bottom surface of the assembly hole 340H may be an upper surface of the first insulating layer 330.

A height (or thickness) of the partition wall 340 may be determined in consideration of a thickness of the semiconductor light emitting element 150A.

A self-assembly process may be performed on the backplane substrate configured as described above, so that the plurality of semiconductor light emitting elements may be assembled into the plurality of subpixels of each of the plurality of pixels on the substrate 310.

As an example, a plurality of red semiconductor light emitting elements, a plurality of green semiconductor light emitting elements, and a plurality of blue semiconductor light emitting elements may be sequentially assembled into a plurality of subpixels of each of a plurality of pixels on the substrate 310. For example, the semiconductor light emitting element may be assembled into an assembly hole 340H of a red subpixel of each of a plurality of subpixels of each of a plurality of pixels on the substrate 310. For example, the green semiconductor light emitting element may be assembled into an assembly hole 340H of a green subpixel of each of a plurality of subpixels of each of a plurality of pixels on the substrate 310. For example, the blue semiconductor light emitting element may be assembled into an assembly hole 340H of a blue subpixel of each of a plurality of subpixels of each of a plurality of pixels on the substrate 310.

As another example, a plurality of red semiconductor light emitting elements, a plurality of green semiconductor light emitting elements, and a plurality of blue semiconductor light emitting elements may be simultaneously assembled into a plurality of subpixels of each of a plurality of pixels on the substrate 310. To this end, a plurality of red semiconductor light emitting elements, a plurality of green semiconductor light emitting elements, and a plurality of blue semiconductor light emitting elements may be dropped into and mixed into the fluid of the chamber. Then, the same self-assembly process may be performed so that the plurality of red semiconductor light emitting elements, the plurality of green semiconductor light emitting elements, and the plurality of blue semiconductor light emitting elements may be simultaneously assembled into the plurality of subpixels of each of the plurality of pixels on the substrate 310.

For the simultaneous self-assembly, the red semiconductor light emitting elements, the green semiconductor light emitting elements, and the blue semiconductor light emitting elements may each have exclusivity with respect to each other. That is, the shapes or sizes of the red semiconductor light emitting elements, the green semiconductor light emitting elements, and the blue semiconductor light emitting elements may be different from each other. For example, the red semiconductor light emitting elements may have a circular shape, the green semiconductor light emitting elements may have a first oval shape having a first minor axis and a first major axis, and the blue semiconductor light emitting elements may have a second oval shape. At this time, the second oval shape may have a second minor axis smaller than the first minor axis and a second major axis larger than the first major axis.

As described above, the red semiconductor light emitting element may be the semiconductor light emitting element 150A according to the first embodiment, but the green semiconductor light emitting element and/or the blue semiconductor light emitting element may also have the same shape, structure and/or function as the semiconductor light emitting element 150A according to the first embodiment, except for the semiconductor material of the light emitting layer 151 to 153.

Meanwhile, after the semiconductor light emitting element is assembled, electrical connection may be completed using a post-process. That is, the connecting electrode 370, the second insulating layer 350, and the electrode wiring 360 may be formed using a post-process.

The connecting electrode 370 may be disposed in the assembly hole 340H. The connecting electrode 370 may electrically connect the semiconductor light emitting element 150A and the first assembly wiring 321 and/or the second assembly wiring 322. For example, the connecting electrode 370 may electrically connect the first electrode 154 of the semiconductor light emitting element 150A and the first assembly wiring 321 and/or the second assembly wiring 322.

As described above, a part of the first electrode 154, i.e., the ohmic contact layer 154-2, may be formed with a step difference d₁ by the insulating layer 156 and the reflective layer 154-1, which are disposed under the first region 150a of the light emitting layer 151 to 153, so that the ohmic contact layer 154-2 under the first region 150a of the light emitting layer 151 to 153 may protrude downward compared to the ohmic contact layer 154-2 under the second region 150b of the light emitting layer 151 to 153. Accordingly, when the semiconductor light emitting element 150A is disposed in the assembly hole 340H, the ohmic contact layer 154-2 under the first region 150a of the light emitting layer 151 to 153 may be in contact with a bottom surface of the assembly hole 340H, that is, an upper surface of the first insulating layer 330, but the ohmic contact layer 154-2 under the second region 150b of the light emitting layer 151 to 153 may not be in contact with the bottom surface of the assembly hole 340H. That is, the ohmic contact layer 154-2 under the second region 150b of the light emitting layer 151 to 153 may be spaced apart from the bottom surface of the assembly hole 340H by at least a step difference d₁. When the first insulating layer 330 is removed within the assembly hole 340H for electrical connection of the connecting electrode 370, the ohmic contact layer 154-2 under the second region 150b of the light emitting layer 151 to 153 may be spaced apart by the sum of a thickness t₄ of the first insulating layer 330 and the step difference d₁. Accordingly, a space corresponding to the sum of the thickness t₄ of the first insulating layer 330 and the step difference d₁ may be formed between the ohmic contact layer 154-2 under the second region 150b of the light emitting layer 151 to 153 and the first assembly wiring 321 and/or the second assembly wiring 322 exposed by the removal of the first insulating layer 330.

Since the connecting electrode 370 is disposed along the perimeter of the semiconductor light emitting element 150A in the assembly hole 340H, the electrical contact area between the connecting electrode 370 and the semiconductor light emitting element 150A can be greatly expanded, so that the luminous efficiency and the light luminance can be improved.

The connecting electrode 370 may be formed using an electroplating or sputtering method.

As an example, the connecting electrode 370 may be formed using an electroplating process. That is, after a plating target, such as a substrate 310, is immersed in an electrolyte, the first assembly wiring 321 and/or the second assembly wiring 322 may be connected to a cathode electrode and a voltage may be applied. A metal film may be coated on the first assembly wiring 321 and/or the second assembly wiring 322, so that the connecting electrode 370 may be formed.

As the metal film is coated on the first assembly wiring 321 and/or the second assembly wiring 322 and gradually becomes thicker, the connecting electrode 370 may be formed along the perimeter of the semiconductor light emitting element 150A in the assembly hole 340H as well as on the lower side of the semiconductor light emitting element 150A. At this time, the connecting electrode 370 may be formed in a space corresponding to the sum of the thickness t₄ of the first insulating layer 330 and the step difference d₁, and may also be formed in a space between the lateral part of the semiconductor light emitting element and the inner side of the assembly hole 340H.

Accordingly, since the connecting electrode 370 is in contact with the ohmic contact layer 154-2 of the first electrode 154 on the lower side of the semiconductor light emitting element 150A, as well as the passivation layer 157 on the lateral part of the semiconductor light emitting element 150A and the ohmic contact layer 154-2 of the first electrode 154, the fixing force of the semiconductor light emitting element 150A can be strengthened.

In addition, a wide separation space corresponding to the sum of the thickness t₄ of the first insulating layer 330 and the step difference d₁ may be formed, so that the semiconductor light emitting element, i.e., the ohmic contact layer 154-2 of the first electrode 154, may be in contact with the lower side and the lateral part. Accordingly, since the connecting electrode 370 has a sufficient thickness, the contact area between the connecting electrode 370 and the ohmic contact layer 154-2 of the first electrode can be maximized, the luminous efficiency and the light luminance can be significantly improved.

As another example, a metal film may be formed and patterned on the substrate 310 using a sputtering process, so that the connecting electrode 370 may be formed along the perimeter of the semiconductor light emitting element 150A in the assembly hole 340H. In addition, a wide separation space corresponding to the sum of the thickness t₄ of the first insulating layer 330 and the step difference d₁ may be formed, so that the metal film may also be formed in the separation space. Accordingly, the formation of the connecting electrode 370 may be facilitated, and the contact area between the connecting electrode 370 and the first electrode 154 can be maximized, so that the luminous efficiency and the light luminance can be significantly improved.

Although not illustrated, instead of the connecting electrode 370, another electrode wiring 360 may be connected to the lateral part of the semiconductor light emitting element 150A through the second insulating layer 350, and may be spaced apart from the electrode wiring 360.

The second insulating layer 350 may be disposed on the partition wall 340. The second insulating layer 350 may be disposed on the semiconductor light emitting element 150A. The second insulating layer 350 may be disposed on the connecting electrode 370 disposed in the assembly hole 340H. The second insulating layer 350 may be a planarizing layer for easily forming the electrode wiring 360 or other layers. Accordingly, the upper surface of the second insulating layer 350 may have a straight plane. The first insulating layer 330 and the second insulating layer 350 may be made of an organic material or an inorganic material. For example, at least one or more of the first insulating layer 330 and the second insulating layer 350 may be made of an organic material.

The electrode wiring 360 may be disposed on the second insulating layer 350 and electrically connected to the semiconductor light emitting element 150A through the second insulating layer 350. For example, the electrode wiring 360 may be electrically connected to the upper side of the light emitting layer 151 to 153 through the second insulating layer 350 and the passivation layer 157 of the semiconductor light emitting element 150A.

Therefore, the semiconductor light emitting element 150A may emit light by the voltage supplied to the first assembly wiring 321 and/or the second assembly wiring 322 and the electrode wiring 360.

### [Second embodiment]

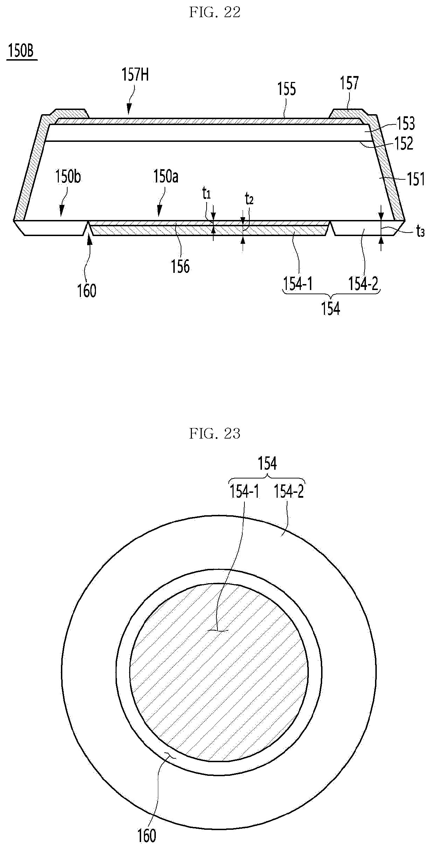

FIG. 22 is a cross-sectional view illustrating a semiconductor light emitting element according to a second embodiment. FIG. 23 is a bottom view illustrating a semiconductor light emitting element according to the second embodiment.

The second embodiment is the same as the first embodiment except for the ohmic contact layer 154-2 of the first electrode 154. In the second embodiment, components having the same shape, structure, and/or function as those in the first embodiment are given the same drawing reference numerals and detailed descriptions are omitted.

Referring to FIGS. 22 and 23, the semiconductor light emitting element 150B according to the second embodiment may comprise a light emitting layer 151 to 153, a passivation layer 157, an insulating layer 156, a first electrode 154, and a second electrode 155.

The insulating layer 156 may be disposed under a first region 150a of the light emitting layer 151 to 153 and may be in contact with a lower surface of the first region 150a of the light emitting layer 151 to 153. The first electrode 154 may comprise a reflective layer 154-1 and an ohmic contact layer 154-2. The reflective layer 154-1 may be disposed under the insulating layer 156 and may form an ODR together with the insulating layer 156. The reflective layer 154-1 may be in contact with a lower surface of the insulating layer 156.

The ohmic contact layer 154-2 may be disposed under the second region 150b of the light emitting layer 151 to 153. That is, in the first embodiment (FIGS. 7 to 9), the ohmic contact layer 154-2 has a structure that surrounds the insulating layer 156 and the reflective layer 154-1, whereas in the second embodiment (FIGS. 22 and 23), the ohmic contact layer 154-2 does not surround the insulating layer 156 and the reflective layer 154-1. That is, in the second embodiment, the ohmic contact layer 154-2 is not formed under the reflective layer 154-1 corresponding to the first region 150a of the light emitting layer 151 to 153, but may be disposed under the second region 150b of the light emitting layer 151 to 153, so that it may contact ta lower surface of the second region 150b of the light emitting layer 151 to 153, that is, a lower surface of the first conductivity type semiconductor layer 151.

The ohmic contact layer 154-2 and the insulating layer 156 may be disposed on the same layer. For example, the ohmic contact layer 154-2 and the insulating layer 156 may be disposed on the lower surface of the light emitting layer 151 to 153. For example, the ohmic contact layer 154-2 and the insulating layer 156 may be disposed on the lower surface of the first conductivity type semiconductor layer 151 of the light emitting layer 151 to 153. For example, the insulating layer 156 may be in contact with a lower surface of a central region of the first conductive semiconductor layer 151 of the light emitting layer 151 to 153, and the ohmic contact layer 154-2 may be in contact with a lower surface of an edge region surrounding the central region of the first conductive semiconductor layer 151.

For example, a thickness t₃ of the ohmic contact layer 154-2 may be equal to the sum of a thickness t₁ of the insulating layer 156 and a thickness t₂ of the reflective layer 154-1. In this instance, the lower surface of the ohmic contact layer 154-2 and the lower surface of the reflective layer 154-1 may be positioned on the same horizontal line. Accordingly, when the semiconductor light emitting element 150B according to the second embodiment is assembled into the assembly hole 340H of the backplane substrate, the ohmic contact layer 154-2 and the reflective layer 154-1 may each be in contact with the bottom surface of the assembly hole 340H, i.e., the upper surface of the first insulating layer 330. In this way, since self-assembling, the ohmic contact layer 154-2 and the reflective layer 154-1 of the semiconductor light emitting element 150B according to the second embodiment are in contact with the bottom surface of the assembly hole 340H at the same time, the semiconductor light emitting element 150B according to the second embodiment may be stably assembled into the assembly hole 340H without shaking or tilting, so that assembly defects can be reduced.

Meanwhile, the ohmic contact layer 154-2 and the insulating layer 156 may be in contact with each other on the lower surfaces of the light emitting layer 151 to 153, but is not limited thereto.

As illustrated in FIG. 23, a recess 160 may be formed between the reflective layer 154-1 and the ohmic contact layer 154-2. That is, the ohmic contact layer 154-2 may be disposed along the perimeter of a lateral part of the reflective layer 154-1, and the recess 160 may be formed such that the ohmic contact layer 154-2 and the reflective layer 154-1 are spaced apart from each other. The spacing of the recesses 160 may increase from the upper side in contact with the lower surface of the light emitting layer 151 to 153 to the lower side of the ohmic contact layer 154-2, but is not limited thereto.

After self-assembly, a connecting electrode 370 may be formed in the recess 160 by a post-process. In this instance, the connecting electrode 370 may be formed not only in the space between the lateral part of the semiconductor light emitting element and the inner side of the assembly hole 340H, but also in the recess 160, so that the semiconductor light emitting element can be firmly fixed by the connecting electrode 370, thereby enhancing the fixing property of the semiconductor light emitting element.

### [Third Embodiment]

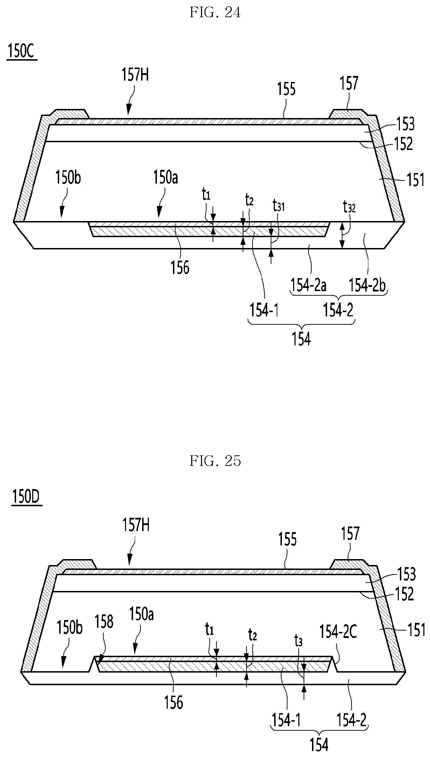

FIG. 24 is a cross-sectional view illustrating a semiconductor light emitting element according to a third embodiment.

The third embodiment is the same as the first embodiment except for the ohmic contact layer 154-2 of the first electrode 154. In the third embodiment, components having the same shape, structure, and/or function as those of the first embodiment are given the same drawing reference numerals and detailed descriptions are omitted.

Referring to FIG. 24, the semiconductor light emitting element 150C according to the third embodiment may comprise a light emitting layer 151 to 153, a passivation layer 157, an insulating layer 156, a first electrode 154, and a second electrode 155.

The insulating layer 156 may be disposed under the first region 150a of the light emitting layer 151 to 153, and may contact a lower surface of the first region 150a of the light emitting layer 151 to 153. The first electrode 154 may comprise a reflective layer 154-1 and an ohmic contact layer 154-2. The reflective layer 154-1 may be disposed under the insulating layer 156, and may form an ODR together with the insulating layer 156. The reflective layer 154-1 may contact a lower surface of the insulating layer 156.

The ohmic contact layer 154-2 may surround the insulating layer 156 and the reflective layer 154-1. At this time, a lower surface of the ohmic contact layer 154-2 may have a straight plane. That is, the ohmic contact layer 154-2 may have a straight plane under the first region 150a and the second region 150b of the light emitting layer 151 to 153. In other words, the ohmic contact layer 154-2 may be positioned on the same horizontal line under the first region 150a and the second region 150b of the light emitting layer 151 to 153.

Meanwhile, since the ohmic contact layer 154-2 and the insulating layer 156 are in contact with the lower surface of the light emitting layer 151 to 153, and the ohmic contact layer 154-2 surrounds the insulating layer 156 and the reflective layer 154-1, and the lower surface of the ohmic contact layer 154-2 has a straight plane, the ohmic contact layer 154-2 may be different from under the first region 150a and the second region 150b of the light emitting layer 151 to 153.

The ohmic contact layer 154-2 may comprise a first ohmic contact layer 154-2a under the first region 150a of the light emitting layer 151 to 153 and a second ohmic contact layer 154-2b under the second region 150b of the light emitting layer 151 to 153. A thickness t₃₂ of the second ohmic contact layer 154-2b may be greater than a thickness t₃₁ of the first ohmic contact layer 154-2a.

Looking at the manufacturing process, the process of forming the insulating layer 156 and the reflective layer 154-1 on the light emitting layer 151 to 153 may be the same as the manufacturing process illustrated in FIGS. 13 to 18. Thereafter, the metal film for the ohmic contact may be formed thicker than that illustrated in FIG. 19. For example, the thickness of the metal film for the ohmic contact on the second region 150b of the light emitting layer 151 to 153 may be formed to be at least greater than the sum of the thickness of the insulating layer 156 and the thickness of the reflective layer 154-1. In this instance, the metal film for ohmic contact on the first region 150a of the light emitting layer 151 to 153 may protrude upward more than the metal film for ohmic contact on the second region 150b of the light emitting layer 151 to 153. Thereafter, the metal film for ohmic contact on the first region 150a of the light emitting layer 151 to 153 that protrudes in this manner may be removed by an etching process or a developing process until the metal film for ohmic contact on the second region 150b of the light emitting layer 151 to 153 is positioned on the same horizontal line. Accordingly, the metal film for ohmic contact on the first region 150a of the protruding light emitting layer 151 to 153 may be removed, whereas the metal film for ohmic contact on the second region 150b of the light emitting layer 151 to 153 is not removed, so that the thickness of the metal film for ohmic contact on the second region 150b of the light emitting layer 151 to 153 may be greater than the thickness of the metal film of the ohmic contact layer 154-2 formed on the first region 150a of the light emitting layer 151 to 153.

In this way, the ohmic contact layer 154-2 may be disposed on an entire region of the lower surface of the light emitting layer 151 to 153, and since the lower surface of the ohmic contact layer 154-2 has a straight plane, the entire region of the ohmic contact layer 154-2 of the semiconductor light emitting element 150C according to the third embodiment may be simultaneously in contact with the bottom surface of the assembly hole 340H during self-assembly, so that the semiconductor light emitting element 150C according to the third embodiment may be stably assembled into the assembly hole 340H without shaking or tilting, thereby reducing assembly defects.

### [Fourth embodiment]

FIG. 25 is a cross-sectional view illustrating a semiconductor light emitting element according to a fourth embodiment. FIG. 26 is a cross-sectional view illustrating a recess formed in the light emitting layer.

The fourth embodiment is the same as the second embodiment except that the insulating layer 156 and the reflective layer 154-1 are disposed in the recess 158. In the fourth embodiment, components having the same shape, structure, and/or function as those of the second embodiment are given the same drawing reference numerals and detailed descriptions are omitted. Meanwhile, the fourth embodiment may be equally applied to the first embodiment or the third embodiment.

Referring to FIG. 25, the semiconductor light emitting element 150D according to the fourth embodiment may comprise a light emitting layer 151 to 153, a passivation layer 157, an insulating layer 156, a first electrode 154, and a second electrode 155.

As illustrated in FIG. 26, a recess 158 may be formed on a lower surface of the light emitting layer 151 to 153. The recess 158 may be formed on the lower surface of the first region 150a of the light emitting layer 151 to 153. A depth d₂ of the recess 158 may be equal to the sum of a thickness t₁ of the insulating layer 156 and a thickness t₂ of the reflective layer 154-1 of the first electrode 154, but is not limited thereto. In this instance, the ohmic contact layer 154-2 may be formed on an entire region of the lower surfaces of the light emitting layer 151 to 153. At this time, when a thickness of the entire region of the ohmic contact layer 154-2 is the same, the lower surface of the ohmic contact layer 154-2 may have a straight plane. The first electrode 154 may be formed by the reflective layer 154-1 and the ohmic contact layer 154-2. In this way, since the lower surface of the ohmic contact layer 154-2 has a straight plane, the entire region of the ohmic contact layer 154-2 of the semiconductor light emitting element 150D according to the fourth embodiment may be simultaneously in contact with the bottom surface of the assembly hole 340H during self-assembly, so that the semiconductor light emitting element 150D according to the fourth embodiment may be stably assembled into the assembly hole without shaking or tilting, thereby reducing assembly defects.

The recess 158 may be formed before the insulating layer 156 and the reflective layer 154-1 are formed (FIG. 18). As illustrated in FIG. 17, an etching process may be performed to remove the upper surface of the light emitting layer 151 to 153, that is, the upper surface of the first region 150a of the light emitting layer 151 to 153, through the opening 445 of the photosensitive film 440, thereby forming the recess 158. Thereafter, the insulating layer 156 and the reflective layer 154-1 may be formed in the recess 158 by depositing the photosensitive film 440 illustrated in FIG. 17 as a mask (FIG. 18). As illustrated in FIGS. 17 and 18, the formation of the recess 158 and the formation of the insulating layer 156 and the reflective layer 154-1 may be performed using the same photosensitive film 440 as a mask, so that the process cost and process time can be reduced.

According to the fourth embodiment, a recess 158 may be formed on the lower surface of the light emitting layer 151 to 153, and an insulating layer 156 and a reflective layer 154-1 may be formed in the recess 158, so that an additional process of forming the ohmic contact layer 154-2 thickly to form a straight plane on the lower surface of the ohmic contact layer 154-2 and then removing a part of the protruding region is not required, so that the process can be simple and the process time can be shortened.

Meanwhile, the ohmic contact layer 154-2 may comprise a protruding part 154-2c. The protruding part 154-2c may be disposed in the recess 158. As illustrated in FIG. 25, a width of the recess 158 may become smaller as it goes deeper from the lower surface of the light emitting layer 151 to 153, whereas a width of the insulating layer 156 and the reflective layer 154-1 may become larger along an upper direction. In this instance, when the insulating layer 156 and the reflective layer 154-1 are formed in the recess 158, a residual gap space of the recess 158 may be formed between the insulating layer 156 and the inner side of the recess 158 and between the reflective layer 154-1 and the inner side of the recess 158. The residual gap space may be formed around the perimeter of the insulating layer 156 and around the perimeter of the reflective layer 154-1. That is, the residual gap space may surround the insulating layer 156 and the reflective layer 154-1, respectively. Since the ohmic contact layer 154-2 is formed on the entire region of the lower surface of the light emitting layer 151 to 153, the ohmic contact layer 154-2 may be formed not only under the reflective layer 154-1 and under the second region 150b of the light emitting layer 151 to 153, but also in the residual gap space of the recess 158. In this instance, the member formed in the residual gap space of the recess 158 may be called a protruding part 154-2c, but may also be called an extension part, a projection, etc. Accordingly, the protruding part 154-2c may be formed around the perimeter of the insulating layer 156 and around the perimeter of the reflective layer 154-1. For example, the protruding part 154-2c may surround the insulating layer 156 in the recess 158. For example, the protruding part 154-2c may surround the reflective layer 154-1 in the recess 158.

The insulating layer 156 and the reflective layer 154-1 may be firmly adhered to the light emitting layer 151 to 153 within the recess 158 by the protruding part 154-2c of the ohmic contact layer 154-2, so that the insulating layer 156 and the reflective layer 154-1 are not peeled off from the light emitting layer 151 to 153.

The fifth to eighth embodiments described below are identical to the first to fourth embodiments, respectively, except for the magnetic layer 154-3 included in the first electrode 154. In the fifth to eighth embodiments, components having the same shape, structure, and/or function as those in the first to fourth embodiments are given the same drawing reference numerals and detailed descriptions are omitted.

### [Fifth embodiment]

FIG. 27 is a cross-sectional view illustrating a semiconductor light emitting element according to a fifth embodiment.

The fifth embodiment is the same as the first embodiment (FIG. 7)) except for the magnetic layer 154-3.

Referring to FIG. 27, the semiconductor light emitting element 150E according to the fifth embodiment may comprise a light emitting layer 151 to 153, a passivation layer 157, an insulating layer 156, a first electrode 154, and a second electrode 155.

The insulating layer 156 may be disposed under the first region 150a of the light emitting layer 151 to 153.

The first electrode 154 may comprise a reflective layer 154-1, an ohmic contact layer 154-2, and a magnetic layer 154-3.

The reflective layer 154-1 may be disposed under the insulating layer 156, and the ohmic contact layer 154-2 may be disposed under each of the reflective layer 154-1 and the second region 150b of the light emitting layer 151 to 153. The ohmic contact layer 154-2 may surround the insulating layer 156 and the reflective layer 154-1. For example, the ohmic contact layer 154-2 may be in contact with a lower surface of the reflective layer 154-1 and a lower surface of the second region 150b of the light emitting layer 151 to 153.

Meanwhile, the magnetic layer 154-3 may be disposed under the ohmic contact layer 154-2. The magnetic layer 154-3 may be in contact with the lower surface of the ohmic contact layer 154-2, but is not limited thereto.

As described above, the ohmic contact layer 154-2 may have a step difference t₃ due to the insulating layer 156 and the reflective layer 154-1. Since the magnetic layer 154-3 is disposed under the ohmic contact layer 154-2, the magnetic layer 154-3 may also have a step difference d₁. At this time, a step difference d₁ of the magnetic layer 154-3 may be equal to or smaller than the step difference t₃ of the ohmic contact layer 154-2, but is not limited thereto.

The magnetic layer 154-3 may be moved toward the magnet by the magnetic field of the magnet during self-assembly. At this time, as a strength of the magnetization force of the magnetic layer 154-3 increases, the reaction speed for the movement of the magnet may increase, and the assembly rate can be improved by the increase in the reaction speed.

According to the fifth embodiment, since the magnetic layer 154-3 is formed on an entire region of the lower surface of the light emitting layer 151 to 153, an area of the magnetic layer 154-3 increases, so that the magnetization force of the magnetic layer 154-3 increases, so that the reaction speed for the movement of the magnet increases, thereby improving the assembly rate.

According to the fifth embodiment, since the lower side of the semiconductor light emitting element 150E according to the fifth embodiment has a non-uniform surface, the area that the semiconductor light emitting element according to the fifth embodiment is in contact with the bottom surface of the chamber or the upper surface of the substrate 310 decreases, so that the semiconductor light emitting element 150E may not be adsorbed on the bottom surface of the chamber or the upper surface of the substrate 310. Accordingly, since more and more semiconductor light emitting elements participate in self-assembly on the substrate 310, the assembly rate can be improved.

### [Sixth embodiment]

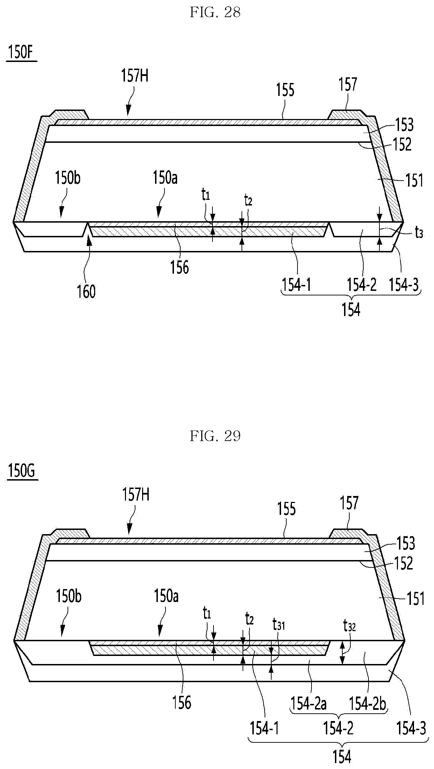

FIG. 28 is a cross-sectional view illustrating a semiconductor light emitting element according to a sixth embodiment.

The sixth embodiment is the same as the second embodiment (FIG. 22) except for the magnetic layer 154-3.

Referring to FIG. 28, the semiconductor light emitting element 150F according to the sixth embodiment may comprise a light emitting layer 151 to 153, a passivation layer 157, an insulating layer 156, a first electrode 154, and a second electrode 155.

The insulating layer 156 may be disposed under the first region 150a of the light emitting layer 151 to 153.

The first electrode 154 may comprise a reflective layer 154-1, an ohmic contact layer 154-2, and a magnetic layer 154-3.

The reflective layer 154-1 may be disposed under the insulating layer 156, and the ohmic contact layer 154-2 may be disposed under the second region 150b of the light emitting layer 151 to 153. The ohmic contact layer may surround the insulating layer 156 and the reflective layer 154-1. That is, the ohmic contact layer 154-2 may be disposed along the perimeter of the insulating layer 156. For example, the ohmic contact layer 154-2 may be disposed along the perimeter of the reflective layer 154-1. A thickness t₃ of the ohmic contact layer 154-2 may be equal to the sum of a thickness t₁ of the insulating layer 156 and a thickness t₂ of the reflective layer 154-1, but is not limited thereto.

A recess 160 may be formed between the reflective layer 154-1 and the ohmic contact layer 154-2. That is, the ohmic contact layer 154-2 may be disposed along the perimeter of a lateral part of the reflective layer 154-1, but the recess 160 may be formed such that the ohmic contact layer 154-2 and the reflective layer 154-1 are spaced apart from each other. The spacing of the recess 160 may increase from the upper side to the lower side of the ohmic contact layer 154-2 that contacts the lower surface of the light emitting layer 151 to 153, but is not limited thereto.

Meanwhile, the magnetic layer 154-3 may be disposed on an entire region of the lower surface of the light emitting layer 151 to 153. For example, the magnetic layer 154-3 may be disposed under the ohmic contact layer 154-2. For example, the magnetic layer 154-3 may be disposed under the reflective layer 154-1. That is, the magnetic layer 154-3 may contact the lower surface of the ohmic contact layer 154-2 and the lower surface of the reflective layer 154-1. The lower surface of the magnetic layer 154-3 may have a straight plane.

The magnetic layer 154-3 may comprise a protruding part 159a. The protruding part 159a may be disposed in a recess 160. The recess 160 may have a width that narrows as it goes into the interior thereof. The protruding part 159a of the magnetic layer 154-3 may be disposed in the recess 160.

The insulating layer 156 and the reflective layer 154-1 and/or the ohmic contact layer 154-2 may be firmly adhered to the light emitting layer 151 to 153 within the recess 160 by the protruding part 159a of the magnetic layer 154-3, thereby preventing the insulating layer 156 and the reflective layer 154-1 and/or the ohmic contact layer 154-2 from being peeled off from the light emitting layer 151 to 153.

### [Seventh Embodiment]

FIG. 29 is a cross-sectional view illustrating a semiconductor light emitting element according to a seventh embodiment.

The seventh embodiment is the same as the third embodiment (FIG. 24) except for the magnetic layer 154-3.

Referring to FIG. 29, the semiconductor light emitting element 150G according to the seventh embodiment may comprise a light emitting layer 151 to 153, a passivation layer 157, an insulating layer 156, a first electrode 154, and a second electrode 155.

The insulating layer 156 may be disposed under the first region 150a of the light emitting layer 151 to 153.

The first electrode 154 may comprise a reflective layer 154-1, an ohmic contact layer 154-2, and a magnetic layer 154-3.

The reflective layer 154-1 may be disposed under the insulating layer 156. The ohmic contact layer 154-2 may surround the insulating layer 156 and the reflective layer 154-1. At this time, the lower surface of the ohmic contact layer 154-2 may have a straight plane. That is, the ohmic contact layer 154-2 may have a straight plane under the first region 150a and the second region 150b of the light emitting layer 151 to 153. In other words, the ohmic contact layer 154-2 may be positioned on the same horizontal line under the first region 150a and the second region 150b of the light emitting layer 151 to 153.

Meanwhile, since the ohmic contact layer 154-2 and the insulating layer 156 are in contact with the lower surface of the light emitting layer 151 to 153, and the ohmic contact layer 154-2 surrounds the insulating layer 156 and the reflective layer 154-1, and the lower surface of the ohmic contact layer 154-2 has a straight plane, the ohmic contact layer 154-2 may be different from under the first region 150a and the second region 150b of the light emitting layer 151 to 153.

The ohmic contact layer 154-2 may comprise a first ohmic contact layer 154-2a under the first region 150a of the light emitting layer 151 to 153 and a second ohmic contact layer 154-2b under the second region 150b of the light emitting layer 151 to 153. The thickness t₃₂ of the second ohmic contact layer 154-2b may be greater than the thickness t₃₁ of the first ohmic contact layer 154-2a.

Meanwhile, the magnetic layer 154-3 may be disposed under the ohmic contact layer 154-2. The magnetic layer 154-3 may be disposed under the first ohmic contact layer 154-2a. The magnetic layer 154-3 may be disposed under the second ohmic contact layer 154-2b. A thickness of the magnetic layer 154-3 may be constant. That is, the thickness of the magnetic layer 154-3 under the first ohmic contact layer 154-2a and the thickness of the magnetic layer 154-3 under the second ohmic contact layer 154-2b may be the same. The lower surface of the magnetic layer 154-3 may have a straight plane.

Since the magnetic layer 154-3 is disposed on the entire region of the lower side of the light emitting layer 151 to 153, that is, the entire region of the lower side of the ohmic contact layer 154-2, the area of the magnetic layer 154-3 may be expanded and the magnetization force can be increased. Accordingly, the reaction speed of the semiconductor light emitting element 150G according to the seventh embodiment to the movement of the magnet during self-assembly may increase, so that the assembly rate can be improved.

Since the lower surface of the magnetic layer 154-3 has a straight plane, the entire region of the lower surface of the magnetic layer 154-3 of the semiconductor light emitting element 150G according to the seventh embodiment may be simultaneously in contact with the bottom surface of the assembly hole 340H during self-assembly, so that the semiconductor light emitting element 150G according to the seventh embodiment may be stably assembled into the assembly hole 340H without shaking or tilting, thereby reducing assembly defects.

### [Eighth Embodiment]

FIG. 30 is a cross-sectional view illustrating a semiconductor light emitting element according to an eighth embodiment.

The eighth embodiment is the same as the fourth embodiment (FIGS. 25 and 26) except for the magnetic layer 154-3.

Referring to FIG. 30, the semiconductor light emitting element 150H according to the eighth embodiment may comprise a light emitting layer 151 to 153, a passivation layer 157, an insulating layer 156, a first electrode 154, and a second electrode 155.

A recess 158 may be formed on the lower surface of the light emitting layer 151 to 153. The recess 158 may be formed on the lower surface of the first region 150a of the light emitting layer 151 to 153.

The insulating layer 156 may be disposed in the recess 158.

The first electrode 154 may comprise a reflective layer 154-1, an ohmic contact layer 154-2, and a magnetic layer 154-3.

The reflective layer 154-1 may be disposed in the recess 158. The reflective layer 154-1 may be disposed under the insulating layer 156. At this time, a depth d₂ of the recess 158 may be equal to the sum of a thickness t₁ of the insulating layer 156 and a thickness t₂ of the reflective layer 154-1.

The ohmic contact layer 154-2 may surround the insulating layer 156 and the reflective layer 154-1. The ohmic contact layer 154-2 may comprise a protruding part 154-2c disposed in the recess 158. The protruding part 154-2c of the ohmic contact layer 154-2 may surround the insulating layer 156 and/or the reflective layer 154-1 in the recess 158. The lower surface of the ohmic contact layer 154-2 may have a straight plane.

Meanwhile, the magnetic layer 154-3 may be disposed under the ohmic contact layer 154-2. The magnetic layer 154-3 may be disposed on an entire region of the lower surface of the ohmic contact layer 154-2. A thickness of the magnetic layer 154-3 may be constant.

Since the magnetic layer 154-3 is disposed on the entire region of the lower side of the light emitting layer 151 to 153, that is, the entire region of the lower side of the ohmic contact layer 154-2, the area of the magnetic layer 154-3 may be expanded, thereby increasing the magnetization force. Accordingly, the reaction speed of the semiconductor light emitting element 150H according to the eighth embodiment to the movement of the magnet during self-assembly may increase, so that the assembly rate can be improved.

Since the lower surface of the magnetic layer 154-3 has a straight plane, the entire region of the lower surface of the magnetic layer 154-3 of the semiconductor light emitting element 150H according to the eighth embodiment may be simultaneously in contact with the bottom surface of the assembly hole 340H during self-assembly, so that the semiconductor light emitting element 150H according to the eighth embodiment may be stably assembled into the assembly hole 340H without shaking or tilting, thereby reducing assembly defects.

The ninth to twelfth embodiments described below are the same as the fifth to eighth embodiments except for the first electrode 154 disposed on the lateral part of the light emitting layer 151 to 153. In the ninth to twelfth embodiments, components having the same shape, structure, and/or function as those in the fifth to eighth embodiments are given the same drawing reference numerals and detailed descriptions are omitted.

### [Ninth embodiment]

FIG. 31 is a cross-sectional view illustrating a semiconductor light emitting element according to a ninth embodiment.

The ninth embodiment is the same as the fifth embodiment (FIG. 27).

Referring to FIG. 31, the semiconductor light emitting element 150I according to the ninth embodiment may comprise a light emitting layer 151 to 153, a passivation layer 157, an insulating layer 156, a first electrode 154, and a second electrode 155.

The insulating layer 156 may be disposed under a first region 150a of the light emitting layer 151 to 153.

The first electrode 154 may be disposed on a lower side and a lateral part of the light emitting layer 151 to 153.

The first electrode 154 may comprise a reflective layer 154-1, an ohmic contact layer 154-2, and a magnetic layer 154-3.

The reflective layer 154-1 may be disposed under the insulating layer 156.

The ohmic contact layer 154-2 may be disposed on a lower side and a lateral part of the light emitting layer 151 to 153. The ohmic contact layer 154-2 may be disposed under the reflective layer 154-1. The ohmic contact layer 154-2 may be disposed under the second region 150b of the light emitting layer 151 to 153. The ohmic contact layer 154-2 may be disposed on the lateral part of the light emitting layer 151 to 153. To this end, unlike the fifth embodiment, in the ninth embodiment, an end of the lower side of the passivation layer 157 may be disposed at a predetermined distance from the lower surface of the light emitting layer 151 to 153, so that a part of the lateral surface of the light emitting layer 151 to 153 may be exposed. In this instance, the ohmic contact layer 154-2 may be disposed on the exposed lateral surface of the light emitting layer 151 to 153. For example, the ohmic contact layer 154-2 may be in contact with the exposed lateral surface of the light emitting layer 151 to 153. Although not illustrated, the ohmic contact layer 154-2 may be disposed on an end region of the lower side of the passivation layer 157 positioned thereon as well as on the lateral surface of the exposed light emitting layer 151 to 153.

Since the ohmic contact layer 154-2 is disposed not only on the lower side of the light emitting layer 151 to 153 but also on the lateral part of the light emitting layer 151 to 153, the electrical contact area between the ohmic contact layer 154-2 and the light emitting layer 151 to 153 can be maximized, so that the luminous efficiency and the light luminance can be significantly improved. In particular, an insulating layer 156 may be disposed under the first region 150a of the light emitting layer 151 to 153 to impede the flow of current I, and since an ohmic contact layer 154-2 is disposed not only on the lower side of the light emitting layer 151 to 153 but also on the lateral part, the current I may flow to the ohmic contact layer 154-2 through not only the edge region of the lower side of the light emitting layer 151 to 153 but also the lateral part of the light emitting layer 151 to 153. Thus, the current spreading effect can be maximized and the light luminance can be further improved.

Meanwhile, the magnetic layer 154-3 may be disposed under the ohmic contact layer 154-2. The magnetic layer 154-3 may be disposed to contact the entire region of the ohmic contact layer 154-2, so that the area of the magnetic layer 154-3 can be maximized. This, the reaction speed of the semiconductor light emitting element 150I according to the ninth embodiment to the magnet during self-assembly can be further increased, so that the assembly rate can be further improved.

FIG. 32 is a cross-sectional view illustrating a display device according to a second embodiment.

The display device 302 according to the second embodiment (FIG. 32) is the same as the display device 301 according to the first embodiment (FIG. 21) except that the semiconductor light emitting element 150I according to the ninth embodiment is mounted instead of the semiconductor light emitting element 150A according to the first embodiment.

Referring to FIG. 32, the display device 302 according to the second embodiment may comprise a backplane substrate, a semiconductor light emitting element 150I, a connecting electrode 370, a second insulating layer 350, and electrode wiring 360.

Since a part of the first electrode 154 in the semiconductor light emitting element 150I is disposed not only on the lower side but also on the lateral part of the light emitting layer 151 to 153, the contact area between the connecting electrode 370 and the first electrode 154 can be expanded, so that the luminous efficiency and the light luminance can be improved.

In addition, a step difference d₁ may be formed in the ohmic contact layer 154-2 by the insulating layer 156 and the reflective layer 154-1 under the first region 150a of the semiconductor light emitting element 150I, and a space may be formed between the lower side of the semiconductor light emitting element and the first assembly wiring 321 and/or the second assembly wiring 322 by at least the step difference d₁, so that the connecting electrode 370 may be easily formed in this space. Accordingly, since the connecting electrode 370 is disposed not only on the lower side of the semiconductor light emitting element but also on the lateral part, the fixation of the semiconductor light emitting element can be strengthened, and the electrical contact characteristics between the first assembly wiring 321 and/or the second assembly wiring 322 and the semiconductor light emitting element are excellent via the connecting electrode 370, so that the luminous efficiency and the light luminance can be improved.

### [Tenth embodiment]

FIG. 33 is a cross-sectional view illustrating a semiconductor light emitting element according to a tenth embodiment.

The tenth embodiment is the same as the sixth embodiment (FIG. 28).

Referring to FIG. 33, the semiconductor light emitting element 150J according to the tenth embodiment may comprise a light emitting layer 151 to 153, a passivation layer 157, an insulating layer 156, a first electrode 154, and a second electrode 155.

The insulating layer 156 may be disposed under a first region 150a of the light emitting layer 151 to 153.

The first electrode 154 may be disposed on a lower side and a lateral part of the light emitting layer 151 to 153.

The first electrode 154 may comprise a reflective layer 154-1, an ohmic contact layer 154-2, and a magnetic layer 154-3.

The reflective layer 154-1 may be disposed under the insulating layer 156.

The ohmic contact layer 154-2 may be disposed on the lower side and the lateral part of the light emitting layer 151 to 153. The ohmic contact layer 154-2 may be disposed under a second region 150b of the light emitting layer 151 to 153. The ohmic contact layer 154-2 may surround the insulating layer 156 and/or the reflective layer 154-1. The ohmic contact layer 154-2 may be disposed on the lateral part of the light emitting layer 151 to 153. The ohmic contact layer 154-2 may be in contact with a lateral surface of the light emitting layer 151 to 153.

Since the ohmic contact layer 154-2 is disposed not only on the lower surface of the light emitting layer 151 to 153 but also on the lateral part of the light emitting layer 151 to 153, the electrical contact area between the ohmic contact layer 154-2 and the light emitting layer 151 to 153 can be maximized, so that the luminous efficiency and the light luminance can be significantly improved. In particular, an insulating layer 156 may be disposed under the first region 150a of the light emitting layer 151 to 153 to impede the flow of current I, and since an ohmic contact layer 154-2 may be disposed not only on the lower side of the light emitting layer 151 to 153 but also on the lateral part, the current I may flow to the ohmic contact layer 154-2 through not only the edge region of the lower side of the light emitting layer 151 to 153 but also the lateral part of the light emitting layer 151 to 153. Thus, the current spreading effect can be maximized and the light luminance can be further improved.

Meanwhile, the magnetic layer 154-3 may be disposed under the ohmic contact layer 154-2. The magnetic layer 154-3 may be disposed under the reflective layer 154-1. Since the magnetic layer 154-3 is disposed to be in contact with not only the reflective layer 154-1 but also the ohmic contact layer 154-2, the area of the magnetic layer 154-3 can be maximized. Thus, the reaction speed of the semiconductor light emitting element 150J according to the tenth embodiment to the magnet during self-assembly may further increase, thereby further improving the assembly rate.

### [Eleventh embodiment]

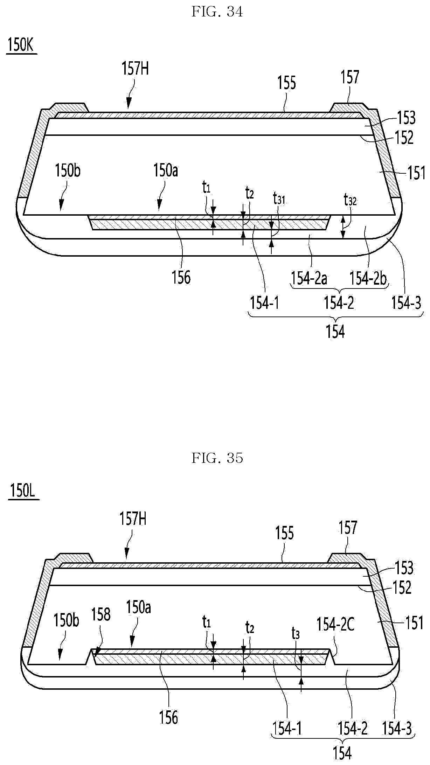

FIG. 34 is a cross-sectional view illustrating a semiconductor light emitting element according to an eleventh embodiment.

The eleventh embodiment is the same as the seventh embodiment (FIG. 29).

Referring to FIG. 34, the semiconductor light emitting element 150K according to the eleventh embodiment may comprise a light emitting layer 151 to 153, a passivation layer 157, an insulating layer 156, a first electrode 154, and a second electrode 155.

The insulating layer 156 may be disposed under a first region 150a of the light emitting layer 151 to 153.

The first electrode 154 may be disposed on a lower side and a lateral part of the light emitting layer 151 to 153.

The first electrode 154 may comprise a reflective layer 154-1, an ohmic contact layer 154-2, and a magnetic layer 154-3.

The reflective layer 154-1 may be disposed under the insulating layer 156.

The ohmic contact layer 154-2 may be disposed on the lower side and the lateral part of the emitting layer 151 to 153. The ohmic contact layer 154-2 may be disposed under the first region 150a of the emitting layer 151 to 153. The ohmic contact layer 154-2 may be disposed under the reflective layer 154-1. The ohmic contact layer 154-2 may be disposed under the second region 150b of the emitting layer 151 to 153. The ohmic contact layer 154-2 may be disposed on the lateral part of the emitting layer 151 to 153. The ohmic contact layer 154-2 may be in contact with the reflective layer 154-1, the second region 150b of the emitting layer 151 to 153, and/or the lateral surface of the emitting layer 151 to 153. As described above, a thickness t₃₁ of the ohmic contact layer 154-2 under the first region 150a of the light emitting layer 151 to 153 may be smaller than a thickness t₃₂ of the ohmic contact layer 154-2 under the second region 150b of the light emitting layer 151 to 153. The lower surface of the ohmic contact layer 154-2 may have a straight plane.

Since the ohmic contact layer 154-2 is disposed not only on the lower side of the light emitting layer 151 to 153 but also on the lateral part of the light emitting layer 151 to 153, the electrical contact area between the ohmic contact layer 154-2 and the light emitting layer 151 to 153 can be maximized, so that the luminous efficiency and the light luminance can be significantly improved. In particular, an insulating layer 156 may be disposed under the first region 150a of the light emitting layer 151 to 153 to impede current flow, and since an ohmic contact layer 154-2 may be disposed not only on the lower side of the light emitting layer 151 to 153 but also on the lateral part current may flow to the ohmic contact layer 154-2 through not only the edge region of the lower side of the light emitting layer 151 to 153 but also the lateral part of the light emitting layer 151 to 153, so that the current spreading effect can be maximized and the light luminance can be further improved.

Meanwhile, the magnetic layer 154-3 may be disposed under the ohmic contact layer 154-2. The magnetic layer 154-3 may be disposed to be in contact with an entire region of the ohmic contact layer 154-2, so that the area of the magnetic layer 154-3 can be maximized. Thus, the reaction speed of the semiconductor light emitting element 150K according to the eleventh embodiment to the magnet during self-assembly may further increase, thereby further improving the assembly rate.

### [Twelfth embodiment]

FIG. 35 is a cross-sectional view illustrating a semiconductor light emitting element according to a twelfth embodiment.

The twelfth embodiment is the same as the eighth embodiment (FIG. 30).

Referring to FIG. 35, the semiconductor light emitting element 150L according to the twelfth embodiment may comprise a light emitting layer 151 to 153, a passivation layer 157, an insulating layer 156, a first electrode 154, and a second electrode 155.

A recess 158 may be formed on a lower surface of the light emitting layer 151 to 153. The recess 158 may be formed on a lower surface of the first region 150a of the light emitting layer 151 to 153.

An insulating layer 156 may be disposed in the recess 158.

The first electrode 154 may comprise a reflective layer 154-1, an ohmic contact layer 154-2, and a magnetic layer 154-3.

The reflective layer 154-1 may be disposed in the recess 158. The reflective layer 154-1 may be disposed under the insulating layer 156. At this time, the depth d₂ of the recess 158 may be equal to the sum of the thickness t₁ of the insulating layer 156 and the thickness t₂ of the reflective layer 154-1.

The ohmic contact layer 154-2 may surround the insulating layer 156 and the reflective layer 154-1. The ohmic contact layer may comprise a protruding part 154-2c disposed in the recess 158. The protruding part 154-2c of the ohmic contact layer 154-2 may surround the insulating layer 156 and/or the reflective layer 154-1 in the recess 158. The lower surface of the ohmic contact layer 154-2 may have a straight plane.

The ohmic contact layer 154-2 may be disposed under a second region 150b of the emitting layer 151 to 153. The ohmic contact layer 154-2 may be disposed on the lateral part of the emitting layer 151 to 153. The ohmic contact layer 154-2 may be in contact with the reflective layer 154-1, the second region 150b of the light emitting layer 151 to 153, and/or the lateral surface of the light emitting layer 151 to 153.

Since the ohmic contact layer 154-2 is disposed not only on the lower side of the light emitting layer 151 to 153 but also on the lateral part of the light emitting layer 151 to 153, the electrical contact area between the ohmic contact layer 154-2 and the light emitting layer 151 to 153 can be maximized, so that the luminous efficiency and the light luminance can be significantly improved. In particular, an insulating layer 156 may be disposed under the first region 150a of the light emitting layer 151 to 153 to impede current flow, and since an ohmic contact layer 154-2 may be disposed not only on the lower side of the light emitting layer 151 to 153 but also on the lateral part, current may flow to the ohmic contact layer 154-2 through not only the edge region of the lower side of the light emitting layer 151 to 153 but also the lateral part of the light emitting layer 151 to 153, so that the current spreading effect can be maximized and the light luminance can be further improved.

Meanwhile, the magnetic layer 154-3 may be disposed under the ohmic contact layer 154-2. The magnetic layer 154-3 may be disposed to contact the entire region of the ohmic contact layer 154-2, so that the area of the magnetic layer 154-3 can be maximized. Thus, the reaction speed of the semiconductor light emitting element according to the eleventh embodiment to the magnet during self-assembly may further increase, thereby further improving the assembly rate.

### [thirteenth embodiment]

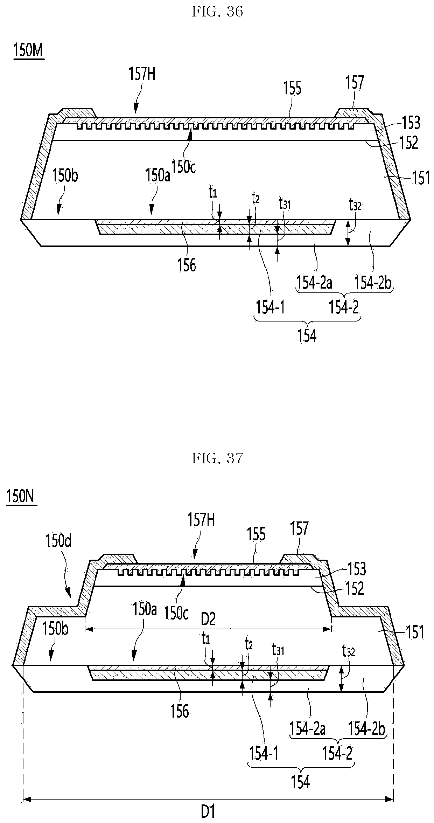

FIG. 36 is a cross-sectional view illustrating a semiconductor light emitting element according to a thirteenth embodiment.

The thirteenth embodiment is the same as the third embodiment (FIG. 24) except for a light extraction pattern 150c. In the thirteenth embodiment, components having the same shape, structure, and/or function as those of the third embodiment are given the same drawing reference numerals and detailed descriptions thereof is omitted. The light extraction pattern 150c may be applied equally to the first embodiment, the second embodiment, and the fourth to twelfth embodiments.

Referring to FIG. 36, the semiconductor light emitting element 150M according to the thirteenth embodiment may comprise a light emitting layer 151 to 153, a passivation layer 157, an insulating layer 156, a first electrode 154, and a second electrode 155.

The light extraction pattern 150c may be formed on an upper side of the light emitting layer 151 to 153. The light extraction pattern 150c may be formed on an upper surface of the second conductivity type semiconductor layer 153 of the light emitting layer 151 to 153. Although not illustrated, a layer comprising the light extraction pattern 150c may be separately disposed on the second conductivity type semiconductor layer 153 of the light emitting layer 151 to 153.

Although the light extraction patterns 150c are depicted as being disposed in the same shape at equal intervals in the drawing, they may be disposed in an irregular shape at non-regular intervals.

The second electrode 155 may be disposed on the light emitting layer 151 to 153. The second electrode 155 may be disposed on the light extraction pattern 150c. A lower surface of the second electrode 155 may have a shape corresponding to the shape of the light extraction pattern 150c. An upper surface of the second electrode 155 may have a straight plane, but is not limited thereto.

Since more of the light generated in the light emitting layer 151 to 153 is extracted to the outside by the light extraction pattern 150c, the luminous efficiency can be increased and the light luminance can be improved.

### [Fourteenth Embodiment]

FIG. 37 is a cross-sectional view illustrating a semiconductor light emitting element according to a fourteenth embodiment.

The fourteenth embodiment is the same as the thirteenth embodiment except for the light emitting layer 151 to 153 having a multi-step structure 150d. In the fourteenth embodiment, components having the same shape, structure, and/or function as those of the thirteenth embodiment are given the same drawing reference numerals and detailed descriptions are omitted. The light emitting layer 151 to 153 having the multi-step structure 150d may be applied in the same manner as those of the first to twelfth embodiments.

Referring to FIG. 37, the semiconductor light emitting element 150N according to the fourteenth embodiment may comprise a light emitting layer 151 to 153, the passivation layer 157, the insulating layer 156, the first electrode 154, and the second electrode 155.

The light emitting layer 151 to 153 may have the multi-step structure 150d. The diameters D1 and D2 (or widths) of the lower and upper regions of the light emitting layer 151 to 153 may be different. For example, the diameter D2 of the upper region of the light emitting layer 151 to 153 may be smaller than the diameter D1 of the lower region of the light emitting layer 151 to 153. For example, a part of the lower region of the light emitting layer 151 to 153 may not vertically overlap with the upper region of the light emitting layer 151 to 153. For example, the thickness of the lower region of the light emitting layer 151 to 153 may be greater than the thickness of the upper region of the light emitting layer 151 to 153, but is not limited thereto.

The lower region of the light emitting layer 151 to 153 may comprise a first conductivity type semiconductor layer 151. The upper region of the light emitting layer 151 to 153 may comprise a first conductivity type semiconductor layer 151, an active layer 152, and a second conductivity type semiconductor layer 153. The lateral surface of the lower region of the light emitting layer 151 to 153 may have an inclined surface. The lateral surface of the upper region of the light emitting layer 151 to 153 may have an inclined surface. At this time, the inclined surface of the lower region of the light emitting layer 151 to 153 and the inclined surface of the upper region of the light emitting layer 151 to 153 may be inclined at the same angle with respect to the ground, but is not limited thereto.

Meanwhile, a semiconductor light-emitting element that does not have a multi-stage structure is moved in an upside-down state and then assembled in an upside-down state in the assembly hole, causing lighting defect due to incorrect assembly. In contrast, the semiconductor light emitting element 150N according to the fourteenth embodiment may have a multi-step structure 150d. Accordingly, since the semiconductor light emitting element 150N according to the fourteenth embodiment may be moved to a correct position without being greatly shaken up and down or flipped over by the magnet during self-assembly, assembly defect may be prevented.

Meanwhile, although not described in the first to fourteenth embodiments, the first electrode 154 may comprise an electrode layer or an adhesive layer. Copper (Cu) may be used as the electrode layer, and chromium (Cr) or titanium (Ti) may be used as the adhesive layer, but is not limited thereto. The electrode layer may be the lowest layer among the plurality of layers included in the first electrode 154. The adhesive layer is for bonding adjacent metal layers, and may be disposed between the reflective layer 154-1 and the ohmic contact layer 154-2, between the reflective layer 154-1 and the magnetic layer 154-3, between the magnetic layer 154-3 and the electrode layer, etc.

Meanwhile, the display device described above may be a display panel. That is, in the embodiment, the display device and the display panel may be understood as having the same meaning. In the embodiment, the display device in the practical sense may comprise a display panel and a controller (or processor) that may control the display panel to display an image.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

### [Industrial Applicability]

The embodiment may be adopted in the display field for displaying images or information. The embodiment may be adopted in the display field for displaying images or information using a semiconductor light emitting element. The semiconductor light emitting element may be a micro-level semiconductor light emitting element or a nano-level semiconductor light emitting element.

For example, the embodiment may be adopted in a TV, a signage, a mobile terminal such as a mobile phone or a smart phone, display for computer such as a laptop or a desktop, a head-up display (HUD) for an automobile, a backlight unit for display, display for VR, AR or mixed reality (MR), a light source, etc.

## Claims

1. A semiconductor light emitting element, comprising:
a light emitting layer having a first region and a second region configured to surround the first region;
a passivation layer configured to surround a lateral part of the light emitting layer;
an insulating layer under the first region;
a first electrode under the light emitting layer; and
a second electrode on the light emitting layer,
wherein the first electrode comprises:
a reflective layer having a shape corresponding to a shape of the insulating layer under the insulating layer;
an ohmic contact layer under the second region; and
a magnetic layer under the ohmic contact layer.

2. The semiconductor light emitting element of claim 1, wherein the ohmic contact layer is configured to surround the reflective layer.

3. The semiconductor light emitting element of claim 2, wherein the ohmic contact layer has a step difference under the first region and the second region.

4. The semiconductor light emitting element of claim 2, wherein the ohmic contact layer has a straight plane under the first region and the second region.

5. The semiconductor light emitting element of claim 4, wherein the ohmic contact layer comprises:
a first ohmic contact layer under the first region; and
a second ohmic contact layer having a thickness greater than a thickness of the first ohmic contact layer under the second region.

6. The semiconductor light emitting element of claim 2, wherein a lower side of the first region of the light emitting layer has a recess, and the insulating layer and the reflective layer are disposed in the recess.

7. The semiconductor light emitting element of claim 6, wherein the ohmic contact layer comprises a protruding part in the recess.

8. The semiconductor light emitting element of claim 7, wherein the protruding part is configured to surround the insulating layer in the recess.

9. The semiconductor light emitting element of claim 7, wherein the protruding part is configured to surround the reflective layer in the recess.

10. The semiconductor light emitting element of claim 1, wherein the magnetic layer is in contact with the ohmic contact layer under the first region.

11. The semiconductor light emitting element of claim 1, wherein the magnetic layer is in contact with the reflective layer under the first region.

12. The semiconductor light emitting element of claim 1, wherein the ohmic contact layer is configured to surround a second lateral part of the light emitting layer.

13. The semiconductor light emitting element of claim 12, wherein the magnetic layer is disposed on the ohmic contact layer on the second lateral part of the light emitting layer.

14. The semiconductor light emitting element of claim 1, wherein the passivation layer comprises an opening on an upper side of the light emitting layer, and the insulating layer has a shape corresponding to a shape of the opening.

15. The semiconductor light emitting element of claim 1, wherein the second electrode comprises a transparent conductive layer.

16. The semiconductor light emitting element of claim 1, wherein an upper surface of the light emitting layer comprises a light extraction pattern.

17. The semiconductor light emitting element of claim 1, wherein the semiconductor light emitting element has a size of micrometers or less.

18. A display device, comprising:
a backplane substrate;
a semiconductor light emitting element in an assembly hole of the backplane substrate;
a connecting electrode on a lateral part of the semiconductor light emitting element in the assembly hole; and
an electrode wiring on the semiconductor light emitting element,
wherein the semiconductor light emitting element comprises:
a light emitting layer having a first region and a second region configured to surround the first region;
a passivation layer configured to surround a lateral part of the light emitting layer;
an insulating layer under the first region;
a first electrode under the insulating layer; and
a second electrode on the light emitting layer,
wherein the first electrode comprises:
a reflective layer having a shape corresponding to a shape of the insulating layer under the insulating layer; and
an ohmic contact layer under the second region,
wherein the connecting electrode is configured to connect the first electrode of the semiconductor light emitting element and at least one or more of the first assembly wiring or the second assembly wiring, and
wherein the electrode wiring is configured to be connected to the second electrode of the semiconductor light emitting element.

19. The display device of claim 18, wherein the connecting electrode is in contact with a lower surface of the first electrode of the semiconductor light emitting element.
